(19) Europäisches Patentamt
European Patent Office
Office européen des brevets

(11) **EP 3 586 360 B1**

(12) **FASCICULE DE BREVET EUROPEEN**

(45) Date de publication et mention de la délivrance du brevet:
**29.12.2021 Bulletin 2021/52**

(21) Numéro de dépôt: **18709686.2**

(22) Date de dépôt: **22.02.2018**

(51) Int Cl.:
*H01L 23/522* (2006.01)    *H01L 27/06* (2006.01)

(86) Numéro de dépôt international:
**PCT/FR2018/050418**

(87) Numéro de publication internationale:
**WO 2018/154242 (30.08.2018 Gazette 2018/35)**

(54) **COMPOSANT ELECTRONIQUE MUNI D'UN TRANSISTOR ET DE DOIGTS INTERDIGITES POUR FORMER AU MOINS UNE PARTIE D'UN COMPOSANT CAPACITIF AU SEIN DU COMPOSANT ELECTRONIQUE**

ELEKTRONISCHES BAUTEIL MIT EINEM TRANSISTOR UND INEINANDERGREIFENDEN FINGERN ZUR BILDUNG MINDESTENS EINES TEILS EINES KAPAZITIVEN BAUTEILS IM ELEKTRONISCHEN BAUTEIL

ELECTRONIC COMPONENT HAVING A TRANSISTOR AND INTERDIGITATED FINGERS TO FORM AT LEAST A PORTION OF A CAPACITIVE COMPONENT WITHIN THE ELECTRONIC COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.02.2017 FR 1751499**

(43) Date de publication de la demande:
**01.01.2020 Bulletin 2020/01**

(73) Titulaire: **Commissariat à l'Energie Atomique et aux Energies Alternatives
75015 Paris (FR)**

(72) Inventeurs:
• **THOLLIN, Benoît
38330 Montbonnot Saint Martin (FR)**
• **CATELAIN, Thibault
Grenoble 38000 (FR)**

(74) Mandataire: **Germain Maureau
12, rue Boileau
69006 Lyon (FR)**

(56) Documents cités:
US-A- 5 744 388    US-A1- 2003 183 864
US-A1- 2007 090 986    US-A1- 2008 265 339
US-A1- 2009 090 951    US-A1- 2015 084 107
US-A1- 2015 236 014    US-B1- 6 410 955

**Description**

**Domaine de l'invention**

Le domaine de l'invention concerne l'électronique, et notamment l'électronique de puissance.

**Etat de la technique**

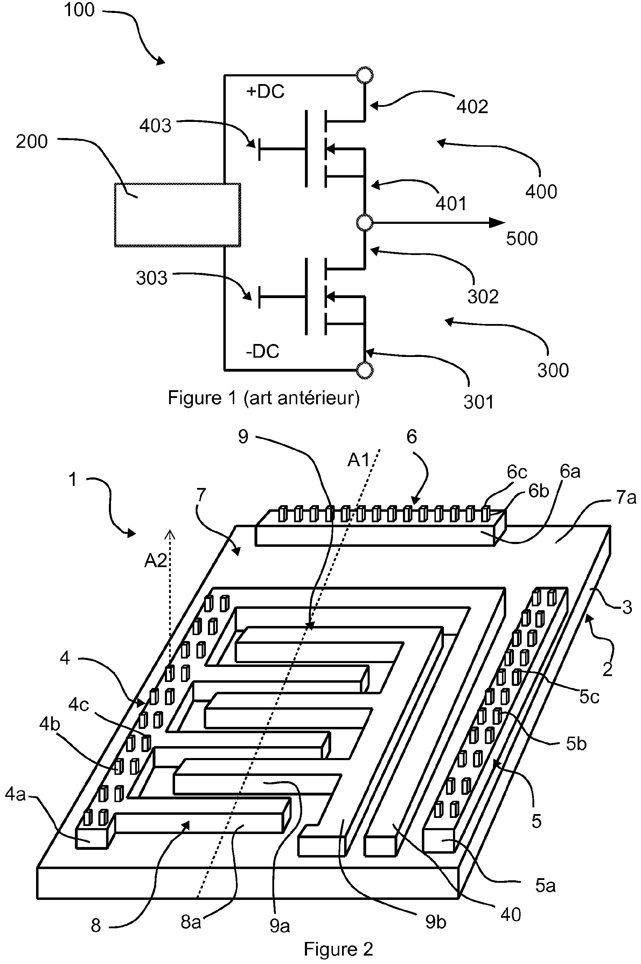

Dans le domaine de l'électronique de puissance où l'on cherche par exemple à former un convertisseur en courant continu vers courant alternatif, il est connu le schéma électrique de la figure 1. Sur ce schéma électrique il est représenté un dispositif 100 comprenant une alimentation électrique 200 de premier et deuxième transistors 300, 400. L'alimentation électrique 200 est apte à appliquer une tension -DC sur la source 301 du premier transistor 300. Le drain 302 du premier transistor 300 est relié à la source 401 du deuxième transistor 400 pour former une sortie 500 en courant alternatif. Par ailleurs, l'alimentation électrique 200 est apte à appliquer une tension +DC sur le drain 402 du deuxième transistor 400. Les grilles 303 et 403 respectivement des premier et deuxième transistors 300, 400 peuvent alors être pilotées pour contrôler la sortie 500. Pour fournir de l'énergie pendant les commutations, il est connu d'utiliser des capacités de découplage proches des composants intégrant le ou les transistors. Il existe donc un besoin de rapprocher les capacités de découplage des transistors.

Le document US2015/0155377 décrit justement une mise en œuvre d'un dispositif réalisant le schéma électrique de la figure 1.

Classiquement, un composant électronique peut être formé à part, puis associé à un composant capacitif distinct. Par exemple, il est connu du document US20080291603 de coupler un circuit intégré à une capacité extérieure.

Le document US2003/0183864 décrit un dispositif comprenant un transistor et deux condensateurs interdigités. Le transistor est situé sur une ligne d'extension imaginaire alignée avec une électrode commune des deux condensateurs interdigités.

Le document « A Silicon Interposer With an Integrated SrTiO3 Thin Film Decoupling Capacitor and Through-Silicon Vias » de Akinobu Shibuya et al. Publié dans IEEE Transactions on components and packaging technologies Vol 33, NO.3 en Septembre 2010 pages 582 à 587 décrit un moyen de coupler une capacité à un transistor. Plus précisément, ce document précise que l'empilement d'une capacité avec une puce distincte de la capacité permet d'améliorer les performances électriques.

Le document US20060006496 décrit la formation de capacités et d'interconnexion des capacités pour, par exemple, un transistor.

Il existe donc clairement un besoin de développer de nouvelles solutions pour par exemple améliorer les intégrations actuelles de transistor avec un composant capacitif, et notamment encore diminuer les inductances parasites pour permettre une augmentation des fréquences de commutation dans le cas particulier de l'électronique de puissance.

**Objet de l'invention**

L'invention a pour but un composant électronique proposant de rapprocher au moins une partie d'un composant capacitif à un transistor pour en améliorer le fonctionnement notamment en permettant un meilleur découplage.

On tend vers ce but grâce à un composant électronique comprenant une partie intégrant un transistor muni d'une électrode de commande et de première et deuxième électrodes, le composant électronique comportant des première, deuxième et troisième bornes de connexion électrique s'étendant sur une face de connexion de ladite partie intégrant le transistor, la première borne de connexion électrique étant en lien électrique avec la première électrode, la deuxième borne de connexion électrique étant en lien électrique avec la deuxième électrode et la troisième borne de connexion électrique étant en lien électrique avec l'électrode de commande. En outre, le composant électronique comporte un premier ensemble de doigts électriquement conducteurs et un deuxième ensemble de doigts électriquement conducteurs, les doigts des premier et deuxième ensembles de doigts étant interdigités, au niveau de la face de connexion, pour former au moins une partie d'un composant capacitif, et les doigts du premier ensemble de doigts sont reliés électriquement à la première borne de connexion électrique.

Des modes de réalisation particuliers de ce composant électronique peuvent être mis en œuvre de telle sorte que ledit composant électronique peut comporter une ou plusieurs des caractéristiques suivantes. Ces caractéristiques du composant électronique correspondent donc à des modes de réalisation particuliers.

Selon une caractéristique du composant électronique, les doigts du premier ensemble de doigts et du deuxième ensemble de doigts s'étendent selon leur longueur parallèlement à la face de connexion.

Selon une caractéristique du composant électronique, au moins une partie de chaque doigt du premier ensemble de doigts forme une continuité de matière avec au moins une partie de la première borne de connexion électrique.

Selon une caractéristique du composant électronique, la première borne de connexion électrique comporte un organe électriquement conducteur s'étendant sur la face de connexion, et les doigts du premier ensemble de doigts forment, avec ledit organe, une continuité de matière.

Selon une caractéristique du composant électronique, la première borne de connexion électrique comporte un organe électriquement conducteur s'étendant sur face de connexion, et une pluralité de piliers reliés électriquement à l'organe agencé entre les piliers et la face de connexion.

Selon une caractéristique du composant électronique, les doigts du premier ensemble de doigts forment une continuité de matière avec l'organe électriquement conducteur de la première borne de connexion électrique. Alternativement chaque doigt du premier ensemble de doigts comporte une première partie longitudinale et une deuxième partie longitudinale, la première partie étant agencée entre la deuxième partie et la face de connexion, lesdites premières parties formant, avec l'organe, une première continuité de matière, et lesdites deuxièmes parties formant chacune, avec un pilier correspondant de la première borne de connexion électrique, une deuxième continuité de matière.

Selon une caractéristique du composant électronique, les doigts du premier ensemble de doigts forment une continuité de matière avec l'organe électriquement conducteur de la première borne de connexion électrique, et le composant électronique comporte un troisième ensemble de doigts électriquement conducteurs et un quatrième ensemble de doigts électriquement conducteurs, les doigts du troisième ensemble de doigts et du quatrième ensemble de doigts étant interdigités, chaque doigt du quatrième ensemble de doigts formant, avec au moins un pilier de la première borne de connexion électrique, une continuité de matière, et :

- chaque doigt du premier ensemble de doigts comporte une partie longitudinale agencée entre une partie longitudinale d'un doigt du troisième ensemble de doigts et la face de connexion,
- chaque doigt du deuxième ensemble de doigts comporte une partie longitudinale agencée entre une partie longitudinale d'un doigt du quatrième ensemble de doigts et la face de connexion,
- les doigts du premier ensemble de doigts sont reliés électriquement aux doigts du quatrième ensemble de doigts,
- les doigts du deuxième ensemble de doigts sont reliés électriquement aux doigts du troisième ensemble de doigts.

Selon une caractéristique du composant électronique, les doigts du premier ensemble de doigts et du deuxième ensemble de doigts sont interdigités entre la face de connexion et un plan situé à distance de la face de connexion et passant par les première, deuxième et troisième bornes de connexion électrique.

Selon une caractéristique du composant électronique, les première, deuxième et troisième bornes de connexion électrique sont agencées à la périphérie de la face de connexion d'où il résulte la présence d'un volume en regard de la face de connexion au sein duquel sont agencés les doigts des premier et deuxième ensemble de doigts.

Selon caractéristique du composant électronique, ledit transistor est un premier transistor dont la première électrode est une électrode de source du premier transistor, la deuxième électrode est une électrode de drain du premier transistor, et l'électrode de commande du premier transistor est une électrode de grille du premier transistor, et le composant électronique comporte :

- un transistor additionnel formant un deuxième transistor muni d'une électrode de grille, d'une électrode de source et d'une électrode de drain,
- une quatrième borne de connexion électrique s'étendant sur la face de connexion et reliée électriquement à l'électrode de grille du deuxième transistor,
- une cinquième borne de connexion électrique s'étendant sur la face de connexion et étant reliée électriquement à l'électrode de drain du deuxième transistor, les doigts du deuxième ensemble de doigts étant reliés électriquement à la cinquième borne de connexion électrique,

l'électrode de source du deuxième transistor étant reliée électriquement à la deuxième borne de connexion électrique, la première borne de connexion électrique étant destinée à être reliée à un potentiel négatif à courant continu d'une alimentation électrique, et la cinquième borne de connexion électrique étant destinée à être reliée à un potentiel positif à courant continu de l'alimentation électrique d'où il résulte que la deuxième borne de connexion électrique forme une sortie apte à fournir un courant alternatif.

L'invention est aussi relative à un dispositif pour la conversion d'énergie électrique, ce dispositif comprenant un premier composant électronique tel que décrit et un deuxième composant électronique tel que décrit, et :

- la première électrode du transistor du premier composant électronique est une électrode de source, et est destinée à être reliée électriquement à un potentiel négatif à courant continu d'une alimentation électrique du dispositif,
- la deuxième électrode du transistor du premier composant électronique est une électrode de drain, et est destinée à être reliée électriquement à une sortie en courant alternatif du dispositif,
- l'électrode de commande du transistor du premier composant électronique est une électrode de grille,
- la première électrode du transistor du deuxième composant électronique est une électrode de drain, et est destinée à être reliée électriquement à un potentiel positif à courant continu de l'alimentation électrique du dispositif,

- la deuxième électrode du transistor du deuxième composant électronique est une électrode de source, et est destinée à être reliée à la sortie en courant alternatif,
- l'électrode de commande du transistor du deuxième composant électronique est une électrode de grille,
- les doigts du premier ensemble de doigts du premier composant électronique sont reliés électriquement aux doigts du deuxième ensemble de doigts du deuxième composant électronique,
- les doigts du deuxième ensemble de doigts du premier composant électronique sont reliés électriquement aux doigts du premier ensemble de doigts du deuxième composant électronique.

L'invention est aussi relative à un procédé de fabrication d'un composant électronique de préférence tel que décrit, un tel procédé comporte :

- une étape de fourniture d'une partie du composant électronique comportant un transistor muni d'une électrode de commande et de première et deuxième électrodes, ladite partie du composant électronique comportant une face de connexion destinée à permettre la formation de bornes de connexion électrique du composant électronique,
- une étape de formation de première, deuxième et troisième bornes de connexion électrique dudit composant électronique au niveau de la face de connexion de telle sorte que :

    ◦ la première borne de connexion électrique soit reliée électriquement à la première électrode du transistor,
    ◦ la deuxième borne de connexion électrique soit reliée électriquement à la deuxième électrode du transistor et,
    ◦ la troisième borne de connexion électrique soit reliée électriquement à l'électrode de commande du transistor,

le procédé comporte en outre une étape de formation d'un premier ensemble de doigts électriquement conducteurs et d'un deuxième ensemble de doigts électriquement conducteurs de telle sorte que :

    ◦ les doigts du premier ensemble de doigts et du deuxième ensemble de doigts soient interdigités, au niveau de la face de connexion, pour former au moins une partie d'un composant capacitif, et
    ◦ les doigts du premier ensemble de doigts soient reliés électriquement à la première borne de connexion électrique.

Selon une réalisation particulière du procédé, l'étape de formation des première, deuxième et troisième bornes de connexion électrique et l'étape de formation du premier ensemble de doigts électriquement conducteurs et du deuxième ensemble de doigts électriquement conducteurs sont telles qu'au moins une partie de la première borne de connexion électrique, et au moins une partie de chacun des doigts du premier ensemble de doigts sont formés simultanément.

Par exemple, ladite au moins une partie de la première borne de connexion électrique et ladite au moins une partie de chacun des doigts du premier ensemble de doigts sont formées simultanément par une étape de formation d'une couche électriquement conductrice sur la face de connexion, puis une étape de gravure de ladite couche électriquement conductrice.

L'étape de gravure de la couche électriquement conductrice peut être telle qu'un organe électriquement conducteur est formé pour chacune des première, deuxième et troisième bornes de connexion, et que les doigts du premier ensemble de doigts forment, avec l'organe de la première borne de connexion électrique, une continuité de matière.

L'étape de formation des première, deuxième et troisième bornes de connexion électrique peut comporter une étape de réalisation, pour chacune des première, deuxième et troisième bornes de connexion électrique, d'un organe électriquement conducteur surmonté de piliers électriquement conducteurs, et au moins une partie de chacun des doigts du premier et du deuxième ensembles de doigts et les piliers sont formés simultanément par croissance selon un masque de croissance.

**Description sommaire des figures**

L'invention sera mieux comprise à la lecture de la description qui va suivre, donnée uniquement à titre d'exemple non limitatif et faite en se référant aux dessins sur lesquels :

- La figure 1 illustre un schéma électrique selon l'art antérieur d'un convertisseur d'énergie électrique dont la fonction est celle d'un bras d'onduleur,
- La figure 2 illustre en perspective une réalisation d'un composant électronique selon un mode d'exécution de l'invention,
- La figure 3 illustre une partie du composant électronique de la figure 2,
- La figure 4 illustre un transistor selon l'art antérieur,
- La figure 5 illustre une réalisation particulière du composant électronique vue en perspective,

- Les figures 6 et 7 illustrent une autre réalisation particulière du composant électronique, la figure 7 étant une vue en coupe selon A-A de la figure 6 qui est une vue de dessus du composant électronique,
- La figure 8 illustre selon une vue en coupe schématique un autre mode de réalisation particulier à deux étages de doigts interdigités,
- La figure 9 représente la figure 2 à laquelle il a été rajouté une couche en matériau diélectrique,
- La figure 10 illustre un mode de réalisation d'un composant électronique vu en perspective destiné à participer à la formation d'un convertisseur d'énergie électrique,
- La figure 11 illustre, vue en perspective, la partie du composant électronique de la figure 10 sur laquelle seront formées les bornes de connexion et les doigts interdigités,
- Les figures 12 et 13 illustrent une réalisation d'un dispositif pour la conversion d'énergie électrique selon des vues en perspective, sur la figure 12 seules des parties de composants électroniques du dispositif sont représentées,
- La figure 14 illustre des étapes d'un procédé de fabrication du composant électronique,
- Les figures 15 à 19 illustrent des vues en coupe permettant d'illustrer des étapes d'un procédé de fabrication du composant électronique.

Sur ces figures, les mêmes références sont utilisées pour désigner les mêmes éléments.

Par ailleurs, les éléments représentés sur les figures ne sont pas nécessairement à l'échelle pour faciliter la compréhension des figures.

## Description de modes particuliers de réalisation

Le composant électronique décrit ci-après diffère de l'art antérieur notamment en ce qu'il propose de former au moins une partie d'un composant capacitif au plus près d'un transistor du composant électronique dont une face de connexion comporte des bornes de connexion du composant électronique reliées aux électrodes du transistor. Pour cela, il est proposé d'intégrer cette partie du composant capacitif directement au composant électronique. De préférence, l'intégration de ladite au moins une partie du composant capacitif est réalisée au cours de la formation des bornes de connexion du composant électronique.

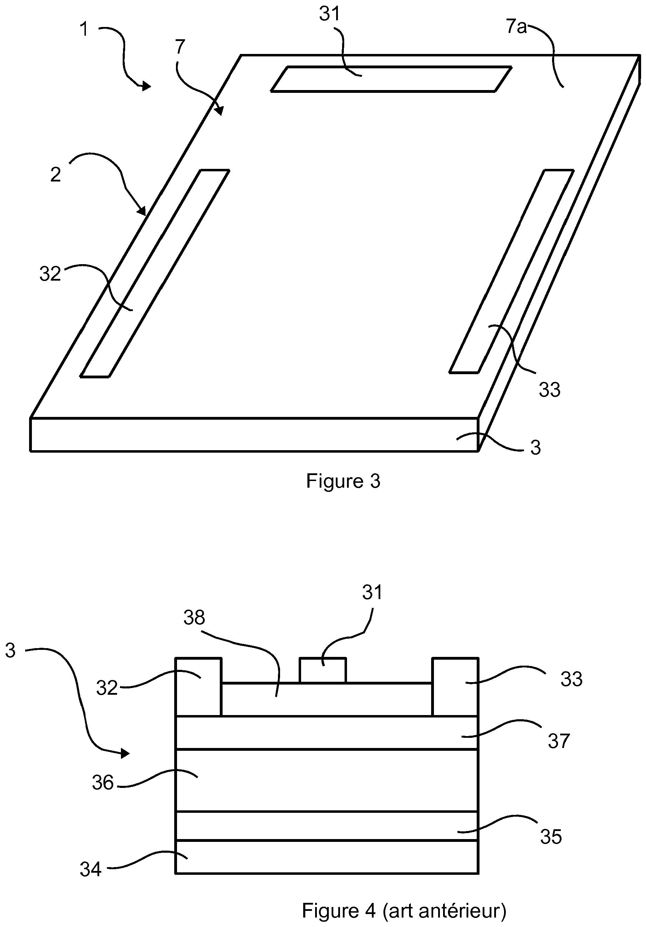

Comme illustré en figures 2 et 3, le composant électronique 1 comprend une partie 2 intégrant (c'est-à-dire comportant) un transistor 3. Le transistor 3 est muni d'une électrode de commande 31 et de première et deuxième électrodes 32, 33. Le composant électronique 1 comporte des première, deuxième et troisième bornes de connexion électrique 4, 5, 6 (figure 2) s'étendant sur une face de connexion 7 de ladite partie 2 intégrant le transistor 3, notamment s'étendant depuis la face de connexion 7 vers une direction opposée à ladite partie 2 intégrant le transistor. Par ailleurs, les première à troisième bornes de connexion électrique 4, 5, 6 peuvent aussi s'étendre longitudinalement sur la face de connexion 7. En particulier, la face de connexion 7 peut comporter une surface délimitée par une couche en matériau isolant électrique 7a et des zones de contact électrique. Les zones de contact électrique sont par exemple délimitées chacune par une surface correspondante d'une des électrodes 31, 32, 33 accessible depuis une ouverture formée dans la couche en matériau isolant électrique 7a. Les première à troisième bornes de connexion 4, 5, 6 sont formées au moins sur les zones de contact électrique. Le matériau isolant électrique peut être du nitrure de silicium $Si_3N_4$, ou de l'oxyde de silicium $SiO_2$, ou de l'oxyde de tantale $Ta_2O_5$, ou du $Al_2O_3$ (oxyde d'aluminium), ou du AlN (nitrure d'aluminium) ou encore du parylène, et permet d'isoler les couches internes du composant électronique. Sur la figure 2, les zones de contact électrique ne sont pas visibles car en contact avec les première à troisième bornes de connexion 4, 5, 6 qui les recouvrent.

Le composant électronique est notamment une puce intégrant le transistor dont les bornes de connexion sont formées au niveau d'une même face, c'est-à-dire qu'elles s'étendent toutes sur une même face dite « face de connexion ».

En particulier, on dit que la première borne de connexion électrique 4 est en lien électrique avec la première électrode 32, que la deuxième borne de connexion électrique 5 est en lien électrique avec la deuxième électrode 33, et que la troisième borne de connexion électrique 6 est en lien électrique avec l'électrode de commande 31. Notamment, la première borne de connexion électrique 4 est agencée sur la première électrode 32, la deuxième borne de connexion électrique 5 est agencée sur la deuxième électrode 33, et la troisième borne de connexion électrique 6 est agencée sur l'électrode de commande 31.

Le composant électronique 1 comporte un premier ensemble 8 de doigts 8a électriquement conducteurs et un deuxième ensemble 9 de doigts 9a électriquement conducteurs. Les doigts 8a, 9a des premier et deuxième ensembles de doigts sont interdigités, au niveau de la face de connexion 7, pour former au moins une partie d'un composant capacitif. Le composant capacitif peut être un composant capacitif de découplage. Le composant capacitif est aussi appelé condensateur. Les doigts interdigités 8a, 9a des premier et deuxième ensembles de doigts 8, 9 sont agencés pour former une partie du condensateur. Par « au niveau de la face de connexion 7 », on entend que la face de connexion 7 est orientée vers les doigts 8a, 9a, et de préférence que les doigts 8a, 9a reposent sur la face de connexion notamment sur la couche en matériau isolant électrique 7a, ou encore sur une couche de passivation interposée entre les doigts 8a, 9a et la face de connexion 7. Par « les doigts reposent sur la face de connexion », on entend qu'ils sont en contact avec cette dernière. Cette notion des doigts interdigités au niveau de la face de connexion peut aussi se traduire par le fait que les doigts 8a du premier ensemble de doigts 8 s'étendent, selon leur longueur, latéralement depuis la première borne de connexion 4. Par ailleurs, les doigts 8a, 9a s'étendent préférentiellement selon leur hauteur depuis la face de connexion 7. La direction latérale est donnée ici selon une direction orthogonale à un vecteur normal à la face de connexion, ce vecteur normal donnant la direction d'extension de la première borne de connexion électrique 4 depuis la face de connexion 7 en s'éloignant de ladite face de connexion 7. Les doigts 8a, 9a des premier et deuxième ensembles de doigts 8, 9 s'étendent notamment sur la couche en matériau isolant électrique 7a.

Par ailleurs, les doigts 8a du premier ensemble 8 de doigts sont reliés électriquement à la première borne de connexion électrique 4. On comprend alors que la première borne de connexion électrique 4 forme préférentiellement un bus de raccordement des doigts 8a du premier ensemble 8 de doigts, ce qui permet de les rapprocher du transistor par rapport à l'art antérieur en les intégrant avec une borne de connexion électrique.

Par « les doigts du premier ensemble 8 et du deuxième ensemble 9 de doigts étant interdigités », on entend qu'il est formé une succession de doigts selon un axe A1, orthogonal aux directions d'extensions longitudinales des doigts. Cette succession de doigts comporte notamment alternativement un doigt du premier ensemble de doigts, puis un doigt du deuxième ensemble de doigts, etc. En particulier, les doigts 8a du premier ensemble 8 de doigts sont tous raccordés électriquement entre eux par la première borne de connexion 4 et les doigts 9a du deuxième ensemble 9 de doigts sont tous raccordés électriquement entre eux, notamment via un bus de raccordement 9b des doigts 9a du deuxième ensemble 9 de doigts. Bien entendu, chaque doigt 8a du premier ensemble 8 de doigts est à distance de chacun des doigts 9a du deuxième ensemble 9 de doigts.

La hauteur des doigts 8a du premier ensemble 8 de doigts est généralement égale à la hauteur des doigts 9a du deuxième ensemble de doigts, la hauteur étant donnée selon un axe orthogonal à la face de connexion 7. Le ou les matériaux des doigts du premier ensemble de doigts et du deuxième ensemble de doigts sont préférentiellement les mêmes.

Les doigts 8a, 9a du premier ensemble 8 de doigts et du deuxième ensemble 9 de doigts s'étendent préférentiellement selon leur longueur parallèlement à la face de connexion 7, et préférentiellement de manière à être en contact avec la face de connexion 7. La couche en matériau isolant électrique 7a permet de limiter les fuites, et notamment les courts-circuits au niveau de la face de connexion 7 entre les bornes de connexion électrique 4, 5, 6, et permet de participer à l'augmentation de la valeur de capacité grâce à sa permittivité relative. Grâce au composant électronique tel que décrit, il est possible de réaliser un découplage au plus près du transistor avec une inductance parasite réduite par rapport aux techniques connues qui proposent de coupler le composant électronique avec un composant capacitif distinct du composant électronique.

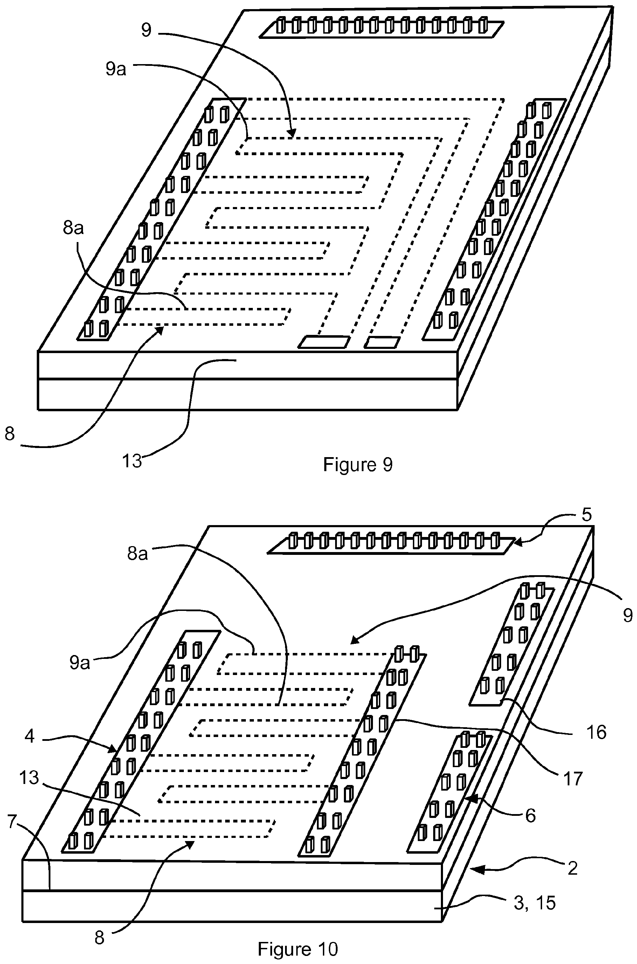

De préférence, un matériau de passivation - aussi appelé matériau diélectrique, pouvant comporter, ou être formé par, du $SiO_2$, ou du $Si_3N_4$, ou du $Al_2O_3$, ou du $Ta_2O_5$, ou du AIN, ou du parylène, est utilisé pour combler les espaces entre les doigts interdigités voir les recouvrir. Le matériau de passivation présente l'intérêt d'augmenter la valeur de la capacité. En effet, plus le matériau de passivation est isolant électrique, plus on peut rapprocher les doigts et donc augmenter la valeur de la capacité. Sans interposition du matériau de passivation l'isolation peut être faite par de l'air, mais cela dégrade la capacité et augmente les risques de court-circuit. En ce sens les doigts 8a, 9a interdigités seront préférentiellement toujours séparés, et notamment recouvert, par le matériau de passivation. Ce point est notamment illustré en figure 9 où les doigts 8a, 9a des premier et deuxième ensembles de doigts 8, 9, recouverts par une couche de passivation 13 en matériau de passivation précité, sont représentés en pointillés.

Dans la présente description, lorsque l'on parle de bornes de connexion électrique 4, 5, 6 du composant électronique, il s'agit de bornes de connexion, ou pattes de connexion, qui permettent la connexion du composant électronique 1 à des éléments tiers extérieurs audit composant électronique 1. Les bornes de connexion 4, 5, 6 sont donc par exemple des bornes de connexion externes du composant électronique destinées à le relier à au moins un composant électronique distinct, par exemple par technique du placement de puce ou « flip-chip » dans le domaine, ou par exemple destinées à accueillir un câblage par fils pour réaliser la connexion électrique. Au moins une partie des bornes de connexion 4, 5, 6 peut donc faire saillie d'une face extérieure du composant électronique.

Par ailleurs, on propose ici d'utiliser un volume, ou région, usuellement laissé « mort », c'est à dire non fonctionnalisé, pour y intégrer les doigts 8a, 9b interdigités. Autrement dit, de préférence, les doigts 8a, 9b du premier ensemble 8 de doigts et du deuxième ensemble 9 de doigts sont interdigités entre la face de connexion 7 et un plan situé à distance de la face de connexion 7, ledit plan étant notamment parallèle à la face de connexion 7, et passant par les première, deuxième et troisième bornes de connexion électrique 4, 5, 6. Notamment, le plan situé à distance de la face de connexion 7 passe par des extrémités des première, deuxième et troisième bornes de connexion électrique 4, 5, 6 distales de la face de connexion 7. Ces extrémités sont dites situées à l'aplomb de la face de connexion 7 lorsque l'on considère cette face de connexion 7 comme définissant l'horizontal. On comprend alors que les doigts 8a, 9a des premier et deuxième ensembles de doigts 8, 9 sont agencés en surface de la partie 2 du composant électronique 1.

De préférence, les première, deuxième et troisième bornes de connexion électrique 4, 5, 6 sont agencées à la périphérie de la face de connexion 7 d'où il résulte la présence d'un volume en regard de la face de connexion 7 au sein duquel sont agencés les doigts 8a, 9a des premier et deuxième ensembles 8, 9 de doigts. Ainsi, on comprend qu'avec cet agencement particulier des bornes de connexion électrique 4, 5, 6, on profite d'un espace central de la face de connexion 7 pour y disposer les doigts interdigités.

En particulier, le transistor, et notamment chaque transistor visé dans la présente description est un transistor de type GaN (nitrure de gallium) à haute mobilité électronique plus particulièrement connu par le sigle HEMT pour l'anglais « High Electron Mobility Transistor ». Pour un tel transistor, les contacts de source, de drain et de grille sont agencés au niveau d'une même face de la puce logeant le transistor. La figure 4 illustre schématiquement et de manière connue un transistor 3 muni d'électrodes de grille 31, de source 32 et de drain 33. Le transistor 3 est formé par un empilement comportant successivement un substrat 34 par exemple en silicium (Si), des couches tampon 35 permettant de compenser le désaccord paramétrique des matériaux (Si et GaN) ainsi que les différences de coefficient de dilatation thermique, une couche en i-GaN 36 (pour GaN intrinsèque), une couche en AlGaN 37 (pour nitrure d'aluminium-gallium), une couche en n-GaN 38 (GaN dopé n). L'électrode de grille 31 est formée sur la couche en n-GaN, l'électrode de source 32 et l'électrode de drain 33 sont formées de part et d'autre de la couche en n-GaN 38 et sont en contact avec la couche en AlGaN 37. L'interface entre les couches en AlGaN et i-GaN permet la création d'un gaz d'électrons à 2 dimensions 2DEG. Une telle structure de transistor est notamment décrite plus en détails dans le document « Outlook for GaN HEMT Technology » de Kazukiyo Joshin et al publié dans « Fujitsu Sci. Tech. J., Vol. 50, No. 1, pp138-143 » en Janvier 2014. D'autres structures peuvent bien entendu être utilisées.

Les transistors GaN ont la particularité d'être planaires, et de proposer leurs connexions électriques sur une même face, dite face avant, d'une puce.

Sur la figure 2 un bras 40 formé en continuité de la première borne de connexion 4 s'étend en partie le long du bus de raccordement 9b des doigts du deuxième ensemble de doigts notamment sur la couche en matériau isolant électrique 7a, son rôle est d'amener une zone de contact électrique en bord du composant électronique en vue de le relier à un autre composant électronique.

Selon une réalisation préférée illustrée en figure 2, chaque doigt 8a, ou au moins une partie de chaque doigt 8a, du premier ensemble de doigts 8 forme une continuité de matière avec au moins une partie de la première borne de connexion électrique 4. De préférence, les doigts 8a du premier ensemble 8 de doigts s'étendent, selon leur longueur, latéralement de la première borne de connexion électrique 4 par rapport à la direction A2 (figure 2) orthogonale à la face de connexion 7. Ainsi, on comprend ici que l'on pousse l'intégration de ladite au moins une partie du composant capacitif en la situant au plus proche du transistor, et de préférence de la première borne de connexion électrique 4 qui peut servir à alimenter le composant électronique 1, notamment lorsque celui-ci est utilisé dans le cadre d'un composant électronique de conversion d'énergie électrique, ou dans un dispositif plus global permettant cette fonction comme cela sera vu par la suite.

Par « continuité de matière », on entend un ensemble cohérent monobloc, notamment fabriqué de manière simultanée. Lorsque des, par exemple deux, choses forment une continuité de matière, on entend qu'elles sont formées dans le même matériau et qu'il n'y a pas de rupture entre ces choses, le matériau peut être par exemple un matériau pur ou un alliage comportant des composés différents. Ces choses ont notamment été obtenues simultanément par dépôt ou croissance du matériau associé. Autrement dit, ladite au moins une partie de la première borne de connexion électrique 4 et ladite au moins une partie de chaque doigt 8 de l'ensemble 8 de doigts font partie d'un seul bloc : ils appartiennent donc à un élément monolithique.

Comme illustré en figure 2, la première borne de connexion électrique 4 peut comporter un organe électriquement conducteur 4a s'étendant sur la face de connexion 7, et de préférence en contact avec la première électrode 32. Eventuellement, la première borne de connexion électrique 4 comporte aussi une pluralité de piliers 4b, de préférence en cuivre. Les piliers 4b sont électriquement conducteurs. Les piliers 4b sont reliés électriquement à l'organe 4a électriquement conducteur qui peut alors former un support pour ces piliers 4b. L'organe 4a électriquement conducteur est agencé entre les piliers 4b et la face de connexion 7. En particulier, on peut aussi dire que les piliers surmontent un organe électriquement conducteur correspondant. Notamment, les piliers 4b s'étendent selon leur longueur ou hauteur dans une direction opposée à la face de connexion 7 et notamment selon un axe orthogonal à la face de connexion 7. Les piliers 4b ne sont pas nécessaires, mais peuvent être utiles pour faciliter la connexion ultérieure ou le report du composant électronique dans des structures tridimensionnelles. Un pilier peut donc être un plot, ou un poteau, de connexion. Dans le cas où les piliers sont présents, ils peuvent être chacun en contact direct avec l'organe électriquement conducteur correspondant ou avec une base (non représentée) issue d'une couche ayant par exemple servie à la croissance du pilier correspondant comme il le sera vu dans le cadre de la description du procédé ci-après. Dans le cas où les piliers 4b ne sont pas présents, la première borne de connexion 4 comporte seulement l'organe 4a. Notamment, on dit que l'organe 4a repose sur la face de connexion 7, de préférence sur une zone de contact électrique de la face de connexion 7 : l'organe 4a est alors en contact avec la première électrode 32. En particulier, les doigts 8a du premier ensemble 8 de doigts forment, avec l'organe 4a électriquement conducteur de la première borne de connexion 4, une continuité de matière.

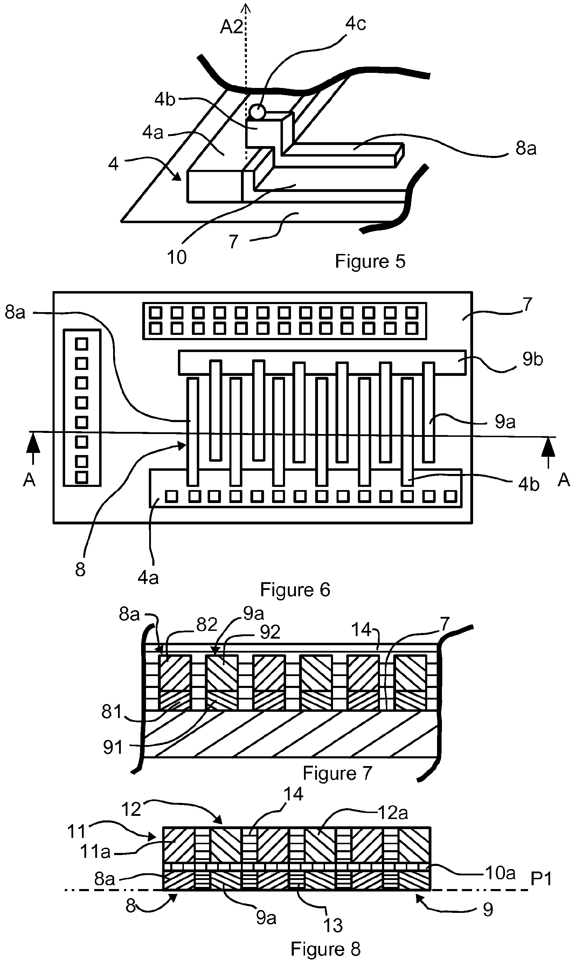

Selon une alternative à la figure 2 illustrée schématiquement en figure 5, chaque doigt 8a du premier ensemble de doigts forme une continuité de matière avec au moins un pilier 4b de la première borne de connexion 4. On comprend donc qu'il existe deux niveaux où l'on peut intégrer les doigts : le niveau organe 4a et le niveau pilier 4b. La figure 5 illustre schématiquement le principe où une continuité de matière comporte le pilier 4b, et s'étend latéralement à la direction A2 pour former aussi un doigt 8a du premier ensemble 8 de doigts. Notamment, sur cette figure 5, une couche de passivation 10 est interposée entre la face de connexion 7 et le doigt 8a. Le matériau de la couche de passivation 10 peut comporter, ou être, du $SiO_2$, du $Si_3N_4$, du $Al_2O_3$, du $Ta_2O_5$, du AlN, ou du parylène. La réalisation de la figure 5 peut être difficile à mettre en œuvre et on préférera celle des figures 2 ou 6 et 7.

Pour la réalisation des figures 6 et 7 les doigts 8a forment une continuité de matière avec l'organe 4a et une continuité de matière avec au moins un pilier 4b. Ici, chaque doigt 8a du premier ensemble 8 de doigts comporte une première partie longitudinale 81 et une deuxième partie longitudinale 82. La première partie longitudinale 81 du doigt correspondant du premier ensemble de doigts étant agencée entre la deuxième partie longitudinale 82 dudit doigt et la face de connexion 7. Les premières parties longitudinales des doigts du premier ensemble de doigts forment, avec l'organe 4a de connexion électrique de la première borne 4, une première continuité de matière, et les deuxièmes parties longitudinales 82 des doigts du premier ensemble de doigts formant chacune, avec un pilier 4b correspondant de la première borne de connexion électrique 4, une deuxième continuité de matière. Ici, chaque première partie longitudinale de doigt peut être en contact direct avec une deuxième partie longitudinale de doigt ou avec interposition d'un matériau issu d'une couche ayant permis la croissance de la deuxième partie longitudinale. Dans ce cas, les doigts 9a du deuxième ensemble de doigts 9 (Figure 6) comportent aussi (figure 7) chacun une première partie longitudinale 91 située au même niveau que les premières parties longitudinales 81 des doigts 8a du premier ensemble de doigts et formant notamment une continuité de matière avec le bus de raccordement des doigts 9a du deuxième ensemble de doigts évoqué ci avant. Ces doigts 9a du deuxième ensemble de doigts 9 comportent aussi chacun une deuxième partie longitudinale 92 agencée au-dessus de la première partie longitudinale 91 des doigts 9a (autrement dit, la première partie 91 est alors agencée entre la deuxième partie 92 et la face de connexion 7), les deuxièmes parties longitudinales étant obtenue de manière similaire aux piliers. En figure 7, la référence 14 représente un matériau de passivation recouvrant les doigts non représenté en figure 6 pour des raisons de clarté, ce matériau peut être tel que celui décrit précédemment. Cette réalisation permet d'augmenter les surfaces en regard de deux doigts adjacents.

Dans le cadre du composant électronique, l'organe 4a électriquement conducteur présente une hauteur depuis la face de connexion 7 qui peut être comprise entre $1\mu m$ et $5\mu m$, et plus particulièrement égale à $4\mu m$. L'organe 4a électriquement conducteur peut présenter une largeur comprise entre $300\mu m$ et 1mm et la longueur de l'organe 4a peut s'adapter à l'espace disponible pour le former. Notamment, la longueur et la largeur d'un organe électriquement conducteur sont mesurées selon des axes orthogonaux entre eux et orthogonaux à un axe mesure de la hauteur dudit organe qui est orthogonal à la face de connexion. Le cas échéant, les piliers peuvent présenter chacun une hauteur (ou longueur) qui peut être comprise entre $5\mu m$ et $30\mu m$, et notamment mesurée selon un axe orthogonal à la face de connexion, et notamment égale à $10\mu m$ Les piliers peuvent présenter chacun une largeur, ou dimension latérale (mesurée orthogonalement à sa hauteur), qui est égale à la hauteur dudit pilier. Bien entendu les dimensions des piliers peuvent être variables en fonction du procédé de fabrication. La hauteur des doigts 8a, 9a selon un axe parallèle à la direction d'extension A2 de la première borne de connexion 4 depuis la face de connexion 7 peut être égale, ou sensiblement égale, le cas échéant, à la hauteur de l'organe 4a en cas de continuité de matière des doigts du premier ensemble 8 de doigts avec l'organe 4a, ou le cas échéant à la hauteur des piliers 4b en cas de continuité de matière des doigts du premier ensemble de doigts avec un ou plusieurs piliers, ou le cas échéant à la somme d'au moins la hauteur de l'organe 4a et d'un pilier correspondant. La hauteur d'un doigt est donc notamment mesurée selon un axe orthogonal à la face de connexion. La longueur des doigts peut être dépendante de la place disponible pour les former. Les doigts interdigités adjacents peuvent être séparés d'une distance comprise entre $1\mu m$ et $100\mu m$ et les doigts peuvent présenter une largeur comprise entre $1\mu m$ et $30\mu m$, ceci étant notamment dépendant des techniques de fabrication utilisées. La largeur d'un doigt est notamment mesurée orthogonalement à sa longueur et à sa hauteur. Le nombre de doigts interdigités peut être fonction de la structure du composant électronique, de préférence on cherchera à maximiser ce nombre selon l'espace disponible pour les former.

Par ailleurs, un plot de brasure 4c (figures 2 et 5), par exemple en alliage SnAg (étain-argent) ou SnAgCu (étain-argent-cuivre) ou AuSn (or-étain) ou AuSi (or-silicium) ou AuGe (or-germanium), peut être formé dans le prolongement de chaque pilier 4b de la première borne de connexion. Pour faciliter la représentation à la figure 2, le plot de brasure correspond à l'extrémité d'un pilier correspondant. Le rôle de ce plot de brasure est de permettre de faciliter la connexion du composant électronique par brasage à un composant tiers. Il est aussi possible de remplacer le plot de brasure par une pâte à fritter.

De préférence, les deuxième et troisième bornes de connexion électrique 5, 6 sont similaires à la première borne de connexion électrique 4. Ainsi, comme illustré en figure 2, la deuxième borne de connexion électrique 5 peut comporter un organe électriquement conducteur 5a s'étendant sur face de connexion 7 et une pluralité de piliers 5b, de préférence en cuivre, qui surmontent l'organe 5a de la deuxième borne de connexion électrique 5 tout en s'étendant selon leur longueur selon un axe orthogonal à la face de connexion 7. De manière similaire, la troisième borne de connexion électrique 6 peut comporter un organe électriquement conducteur 6a s'étendant de la face de connexion 7 et une pluralité de piliers 6b, de préférence en cuivre, qui surmontent l'organe 6a de la troisième borne de connexion électrique 6 tout en s'étendant selon leur longueur selon un axe orthogonal à la face de connexion 7. Par ailleurs, un plot de brasure 5c, 6c, par exemple tel que décrit précédemment, peut être formé au sommet de chaque pilier 5b, 6b. Notamment, les première, deuxième et troisième bornes de connexion électriques 4, 5, 6 ont été formées par des étapes technologiques de microélectronique communes comme il le sera décrit plus en détails ci-après.

Dans la présente description, les piliers sont notamment des piliers en cuivre dont l'extrémité opposée à l'organe électriquement conducteur correspondant est préférentiellement recouverte du plot de brasure. Les piliers en cuivre sont aussi connus dans le domaine sous la dénomination « copper pillar ». Une continuité de matière formée par un doigt, ou une partie de doigt, et un pilier sera donc préférentiellement en cuivre.

Dans la présente description, l'organe électriquement conducteur d'une, notamment de chaque, borne de connexion peut comporter, ou être formé par : un alliage de AlSi (c'est-à-dire aluminium-silicium par exemple composé de 99% at d'aluminium et de 1% at de Silicium, avec % at représentant le pourcentage atomique, dans la suite de la description AlSi représente l'alliage AlSi), ou du cuivre avec une finition d'or pour éviter l'oxydation du cuivre, ou encore de l'aluminium. Autrement dit, le cas échéant, AlSi, ou le cuivre, ou l'aluminium entre dans la composition du matériau formant l'organe électriquement conducteur : une continuité de matière comportant un organe électriquement conducteur et des doigts ou des parties de doigts peut alors être formée par ce matériau.

Selon une mise en œuvre particulière illustrée en figure 8 représentant une coupe d'une portion du composant électronique montrant ladite au moins une partie du composant capacitif, les doigts 8a du premier ensemble 8 de doigts forment une continuité de matière avec l'organe électriquement conducteur de la première borne de connexion électrique par exemple à la manière de ce qui est illustré en figure 2. La figure 8 est une vue en coupe perpendiculaire aux directions d'extensions des doigts permettant de visualiser comment sont interdigités les doigts selon cette mise en œuvre particulière. Ici, le composant électronique comporte un troisième ensemble 11 de doigts 11a électriquement conducteurs et un quatrième ensemble 12 de doigts 12a électriquement conducteurs. Les doigts 8a du premier ensemble de doigts 8 sont reliés électriquement aux doigts 12a du quatrième ensemble de doigts 12 par exemple par l'organe de la première borne de connexion, et les doigts 9a du deuxième ensemble 9 de doigts sont reliés électriquement aux doigts 11a du troisième ensemble 11 de doigts par exemple par le bus de raccordement des doigts 9a du deuxième ensemble de doigts. Les doigts 11a, 12a du troisième ensemble 11 de doigts et du quatrième ensemble 12 de doigts sont interdigités au-dessus des doigts 8a, 9a des premier et deuxième ensembles 8, 9 de doigts pour former une partie correspondante du composant capacitif. Autrement dit, les doigts 8a, 9a des premier et deuxième ensembles 8, 9 de doigts sont interdigités entre la face de connexion et les doigts 11a, 12a des troisième et quatrième ensembles 11, 12 de doigts. Chaque doigt 12a du quatrième ensemble 12 de doigts peut former, avec au moins un pilier 4b de la première borne de connexion électrique 4, une continuité de matière par exemple à la manière de ce qui est illustré en figure 5. En combinant les enseignements des figures 2 et 5, il est possible de réaliser deux doigts distincts superposés et maintenus à distance l'un de l'autre. Chaque doigt 8a du premier ensemble 8 de doigts comporte une partie longitudinale agencée, ou interposée, entre une partie longitudinale d'un doigt 11a du troisième ensemble 11 de doigts et la face de connexion représentée ici schématiquement par le plan P1 perpendiculaire au plan de la figure 8. Par ailleurs, chaque doigt 9a du deuxième ensemble 9 de doigts comporte une partie longitudinale agencée, ou interposée, entre une partie longitudinale d'un doigt 12a du quatrième ensemble 12 de doigts et la face de connexion. On comprend alors qu'il est ici possible de former plusieurs types de capacités au sein d'un même composant électronique au niveau de sa face de connexion. Chacun des doigts 11a du troisième ensemble de doigts est à distance de chacun des doigts 12a du quatrième ensemble de doigts. Les doigts 11a, 12a des deuxième et troisième ensembles de doigts sont à distance des doigts 8a, 9a des premier et deuxième ensembles de doigts. Notamment, les doigts 8a et 12a des premier et quatrième ensembles de doigts sont reliés électriquement à la première borne de connexion électrique, et les doigts 9a et 11a des deuxième et troisième ensembles de doigts sont reliés électriquement entre eux et sont destinés à être reliés à une autre borne de connexion notamment d'un autre transistor. On obtient donc au final trois types de capacités : une latérale à un premier niveau par rapport à la face de connexion entre les doigts interdigités 8a, 9b des premier et deuxième ensembles de doigts ; une autre latérale à un deuxième niveau par rapport à la face de connexion entre les doigts interdigités 11a, 12a des troisième et quatrième ensembles de doigts ; et une verticale entre ces premier et deuxième niveaux. Ici, une couche de passivation 10a est interposée entre le niveau des doigts des premier et deuxième ensembles de doigts et le niveau des doigts des troisième et quatrième ensembles de doigts, cette couche de passivation peut comporter, ou être formée par, du $SiO_2$, ou du $Si_3N_4$, ou du $Ta_2O_5$, ou du AlN, ou du $Al_2O_3$, ou du parylène. En particulier, ici les doigts des premier, deuxième, troisième et quatrième ensembles de doigts sont parallèles entre eux, et les doigts des premier et deuxième ensembles 8, 9 de doigts s'étendent au niveau d'un même plan qui est parallèle au plan d'extension des doigts 11a, 12a du troisième ensemble de doigts et du quatrième ensemble de doigts.

En particulier, sur la figure 8 les doigts 8a, 9a des premier et deuxième ensembles 8, 9 de doigts adjacents sont séparés par un matériau diélectrique 13 - aussi appelé matériau de passivation - tel que celui décrit précédemment (figures 8 et 9) qui peut même recouvrir les doigts 8a, 9a et ainsi être commun à la couche 10a évoqué précédemment. Par ailleurs, il en va de même le cas échéant pour les doigts 11a, 12a des troisième et quatrième ensembles de doigts 11, 12 (figure 8) qui sont séparés par un matériau diélectrique 14 - aussi appelé matériau de passivation - tel que décrit précédemment qui peut être déposé après formation des doigts 11a, 12a (figure 8).

Le choix du matériau diélectrique (ou matériau de passivation) entre les doigts joue un rôle pour l'amélioration de la capacité formée entre deux doigts adjacents de deux ensembles de doigts différents. En ce sens, on dit que les doigts 8a du premier ensemble 8 de doigts et les doigts 9a du deuxième ensemble 9 de doigts sont interdigités de telle sorte que pour tout couple de doigts adjacents, lesdits doigts du couple sont séparés par un matériau diélectrique. Le matériau diélectrique choisi a un rôle pour améliorer la valeur de la capacité comme il l'est décrit ci-après.

La valeur d'une capacité $C$ entre deux doigts adjacents est exprimée en fonction de la permittivité relative du matériau $\varepsilon_r$ utilisé en tant que matériau diélectrique entre deux doigts adjacents interdigités, la permittivité $\varepsilon_0$ électrique du vide, la surface en regard $S$ des deux doigts adjacents interdigités et la distance inter-doigts $e$ suivant la relation (eq. 1).

$$C = \frac{\varepsilon_0 \times \varepsilon_r \times S}{e} \qquad \text{(eq. 1)}$$

De cette équation (eq. 1) il est possible de conclure que pour optimiser la valeur de la capacité, il est possible d'augmenter la surface en regard, et/ou d'augmenter la permittivité relative du matériau diélectrique $\varepsilon_r$ et/ou de réduire la distance $e$. La distance $e$ atteignable dépend en premier lieu de la tenue en tension du matériau diélectrique. Pour un composant électronique destiné à supporter 650V, il est souhaité une tenue en tension autour de 1000V, l'isolant préféré que l'on peut utiliser est le $Si_3N_4$ ou le $SiO_2$. Le $Si_3N_4$ ou le $SiO_2$ déposés sec sont préférés car ils peuvent avoir une rigidité diélectrique de l'ordre de 1000kV/mm. Avec ces matériaux, on peut réduire la distance $e$ à $1\mu m$ pour tenir la tension exigée. De manière connue, la permittivité dépend du matériau choisi, de la surface $S$, de la résolution des doigts (épaisseur et largeur dépendant de « l'aspect ratio » épaisseur divisé par largeur). Pour un procédé standard, l'aspect ratio est autour de 2, ce qui permet d'avoir une largeur de doigt et une distance inter-doigt deux fois plus faible que l'épaisseur déposée. Dans le cas de la présente invention, la valeur de la surface en regard entre deux doigts adjacents peut dépendre de la hauteur du dépôt ainsi que des résines/masques utilisés pour former les doigts du composant électronique qui influent sur la résolution et l'aspect ratio atteignable (largeur des doigts du peigne et espace entre deux doigts ($e$)). Pour la surface disponible en regard de la face de connexion 7, dans l'hypothèse où l'on ne tient pas compte de la valeur de capacité planaire mais uniquement de la capacité latérale c'est-à-dire entre des faces en vis à vis de deux doigts adjacents, cela permet d'atteindre des valeurs de capacité de 600pF. Pour atteindre cette capacité de 600pF les doigts 8a forment chacun une continuité de matière avec au moins un pilier correspondant et présentent les dimensions suivantes : $10\mu m$ de hauteur, $5\mu m$ de large et avec $5\mu m$ de séparation entre doigts, et on utilise un diélectrique de permittivité autour de 7 (comme le $Si_3N_4$ qui lorsqu'il est déposé sec, par exemple par PECVD pour Dépôt chimique en phase vapeur assistée par plasma, permet même de descendre la distance entre doigts à 1 $\mu m$). Dans le cas où les doigts font $2\mu m$ d'épaisseur, $1\mu m$ de large et sont séparés deux à deux de $1\mu m$, la valeur de capacité équivalente avec du $Si_3N_4$ peut atteindre 3000pF, ce cas est notamment possible lorsque les doigts 8a du premier ensemble de doigts forment une continuité de matière avec un organe 4a. Dans le présent paragraphe une hauteur est donnée selon un axe orthogonal à la face de connexion. Dans le présent paragraphe une largeur est donnée selon un axe orthogonal aux axes d'allongement des doigts et à l'axe orthogonal à la face de connexion. Dans le présent paragraphe une dimension de séparation est donnée selon un axe orthogonal aux axes d'allongement des doigts et à l'axe orthogonal à la face de connexion. Le matériau $Ta_2O_5$, notamment déposé sec, présente une permittivité quatre fois supérieure au $Si_3N_4$, et peut être utilisé lorsque les doigts du premier ensemble forment, avec l'organe de la première borne de connexion, une continuité de matière par extension latérale de l'organe car il est difficilement déposable pour des couches allant au-delà de 1 $\mu m$. En ce sens, l'utilisation du $Ta_2O_5$ sera préférée lorsque les doigts sont séparés d'une distance comprise entre $1\mu m$ et 2 $\mu m$.

Autrement dit, il est clair que l'homme du métier est à même d'adapter le procédé de fabrication qui sera décrit ci-après pour former le composant électronique pour obtenir la capacité souhaitée du composant capacitif.

Selon un exemple, lorsque les doigts 8a forment une continuité de matière avec l'organe 4a, les doigts 8a et 9a présentent une hauteur (ou épaisseur) par rapport à la face de connexion 7 de $2\mu m$, une largeur de $1\mu m$, et deux doigts interdigités adjacents de ladite partie du composant capacitif sont préférentiellement séparés d'une distance de $1\mu m$. Les dimensions sont données ici à titre exemplatif, l'homme du métier saura les adapter en fonction du composant capacitif souhaité.

Selon un exemple, lorsque les doigts 8a forment chacun une continuité de matière avec un pilier 4b, les doigts 8a et 9a présentent une hauteur par rapport à la face de connexion 7 de $10\mu m$ une largeur de $5\mu m$, et deux doigts adjacents de ladite partie du composant capacitif sont séparés d'une distance de $5\mu m$. Les dimensions sont données ici à titre exemplatif, l'homme du métier saura les adapter en fonction du composant capacitif souhaité.

De manière générale, lorsque les espaces entre les doigts 8a, 9a des premier et deuxième ensembles de doigts sont comblés par le matériau diélectrique, ce dernier présente une rigidité diélectrique et une permittivité adaptée aux dimensions des doigts, ce matériau peut être notamment, mais non limitativement, du $SiO_2$ ou du $Ta_2O_5$. L'homme du métier saura choisir le matériau diélectrique en fonction de la structure à recouvrir.

De manière générale, la longueur des doigts sera dépendante de l'espace disponible au niveau de la face de connexion 7, par exemple sur certains composants électroniques il peut être possible de profiter d'une zone non occupée de $25mm^2$, ceci dépendant bien entendu de l'architecture du composant électronique.

Plus particulièrement, en fonction des applications visées, le matériau diélectrique choisi pour combler les espaces entre les doigts interdigités doit avoir la plus haute permittivité possible, et ses caractéristiques diélectriques doivent par exemple permettre de tenir 1000V (ceci dépendant du calibre en tension du composant) pour la distance séparant deux doigts adjacents interdigités.

De manière générale, lorsque les doigts du premier ensemble de doigts forment, avec l'organe de la première borne de connexion, une continuité de matière, les surfaces en regard entre doigts sont plus faibles que dans le cas où les doigts du premier ensemble de doigts forment chacun une continuité de matière avec un des piliers 4b, mais il est possible d'avoir une meilleure résolution et donc d'augmenter le nombre de doigts pour augmenter la valeur de la capacité. Lorsque chaque doigt du premier ensemble de doigts forme, avec un pilier correspondant, une continuité de matière, on augmente les surfaces en regard de deux doigts adjacents au détriment de leur nombre. Tout sera donc une affaire de compromis en fonction de ce que l'on cherche à obtenir comme valeur de capacité pour le composant capacitif. D'un point de vue pratique, il est préféré la réalisation où la continuité de matière comporte les doigts 8a et l'organe 4a car ceci permet de former plus facilement des pilier 4b de connexion qui ne seront pas gênés par les doigts pour, par exemple, réaliser de la connexion « flip-chip ».

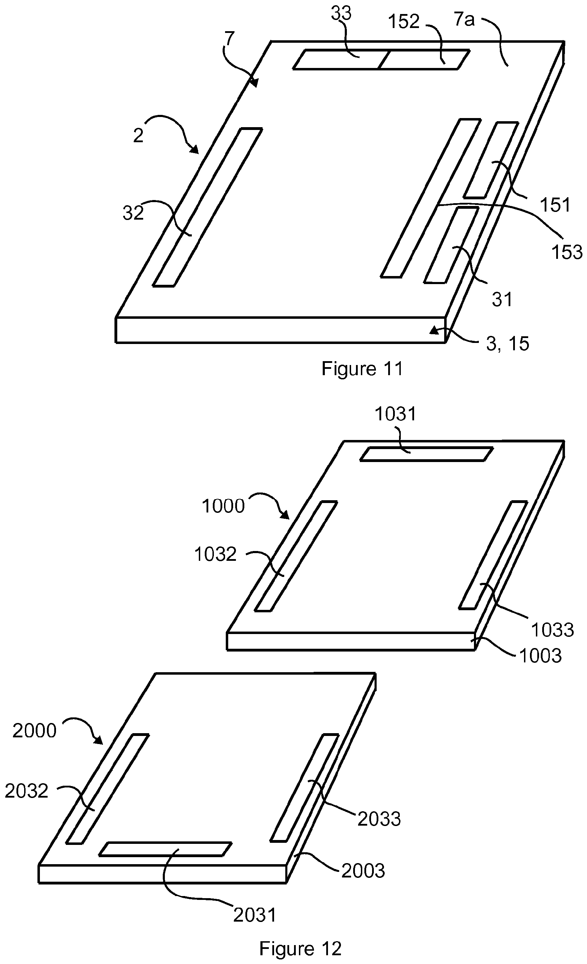

Selon une mise en œuvre illustrée en figures 10 et 11, ledit transistor 3 est un premier transistor 3 dont la première électrode 32 (reliée à la première borne 4) est une électrode de source du premier transistor 3, la deuxième électrode 33 (reliée à la deuxième borne 5) est une électrode de drain du premier transistor 3, et l'électrode de commande 31 (reliée à la troisième borne 6) est une électrode de grille du premier transistor 3. Par ailleurs, le composant électronique comporte un transistor additionnel 15 (logé comme le transistor 3 dans la partie 2 correspondante du composant électronique 1) formant un deuxième transistor 15 muni d'une électrode de grille 151, d'une électrode de source 152 et d'une électrode de drain 153. Une quatrième borne de connexion 16 électrique s'étend sur la face de connexion 7, et est reliée électriquement à l'électrode de grille 151 du deuxième transistor 15. Une cinquième borne de connexion électrique 17 s'étend sur la face de connexion 7, et est reliée électriquement à l'électrode de drain 153 du deuxième transistor 15. Ici, les doigts 9a du deuxième ensemble 9 de doigts sont reliés électriquement à la cinquième borne de connexion électrique 17, et forment de préférence chacun une continuité de matière avec au moins une partie correspondante de la cinquième borne de connexion électrique 17. De préférence, au moins une partie des première et cinquième bornes de connexion ainsi que les doigts 8a, 9a des ensembles 8 et 9 de doigts ont été obtenus simultanément par dépôt ou croissance d'un même matériau. L'électrode de source 152 du deuxième transistor 15 est reliée électriquement à la deuxième borne de connexion électrique 5. Selon cette mise en œuvre, la première borne de connexion électrique 4 est destinée à être reliée à un potentiel négatif à courant continu d'une alimentation électrique et la cinquième borne de connexion électrique 17 est destinée à être reliée à un potentiel positif à courant continu de l'alimentation électrique d'où il résulte que la deuxième borne de connexion 5 électrique forme une sortie apte à fournir un courant alternatif lorsque les grilles des premier et deuxième transistors 3, 15 sont pilotées de manière adaptée. Ici le premier transistor est aussi appelé dans le domaine transistor « low side » et le deuxième transistor est aussi appelé dans le domaine transistor « high side » Autrement dit, selon cette mise en œuvre, le composant électronique peut être utilisé pour former un convertisseur d'énergie électrique, notamment apte à fournir une énergie alternative lorsque l'alimentation est continue. Ici, l'intégration est optimisée puisqu'à partir d'un même composant électronique, on forme un composant d'électronique apte à faire de la conversion de courant. Le composant capacitif est ici formé par les doigts 8a, 9a des premier et deuxième ensembles de doigts représentés en pointillés qui sont préférentiellement séparés et recouverts par un matériau diélectrique 13 (ou matériau de passivation), notamment du type tel que décrit précédemment pour réaliser la passivation des doigts. En particulier, ici le composant électronique peut être monté à un composant de contrôle comportant un système de contrôle des grilles des premier et deuxième transistors ainsi qu'une source de courant continu reliée à l'électrode de source du premier transistor et à l'électrode de drain du deuxième transistor. Ce mode est préféré car il présente une très bonne intégration et permet de former un bras de pont, ou bras d'onduleur, avec une partie de sa capacité de découplage, un condensateur extérieur au composant électronique peut être ajouté pour compléter la valeur de capacité souhaitée.

De préférence, le composant électronique ou les composants électroniques peuvent être utilisés pour former un convertisseur d'énergie électrique permettant une commutation en courant-tension de telle sorte que lorsqu'un transistor est ouvert, il ne laisse plus passer le courant mais tient la tension. Typiquement, le convertisseur d'énergie électrique admet en entrée une tension continue qui peut atteindre plusieurs kV et, pour fournir de l'énergie lors de commutations, le composant capacitif, aussi appelé capacité (ou condensateur) de découplage, doit être placé au plus près des transistors.

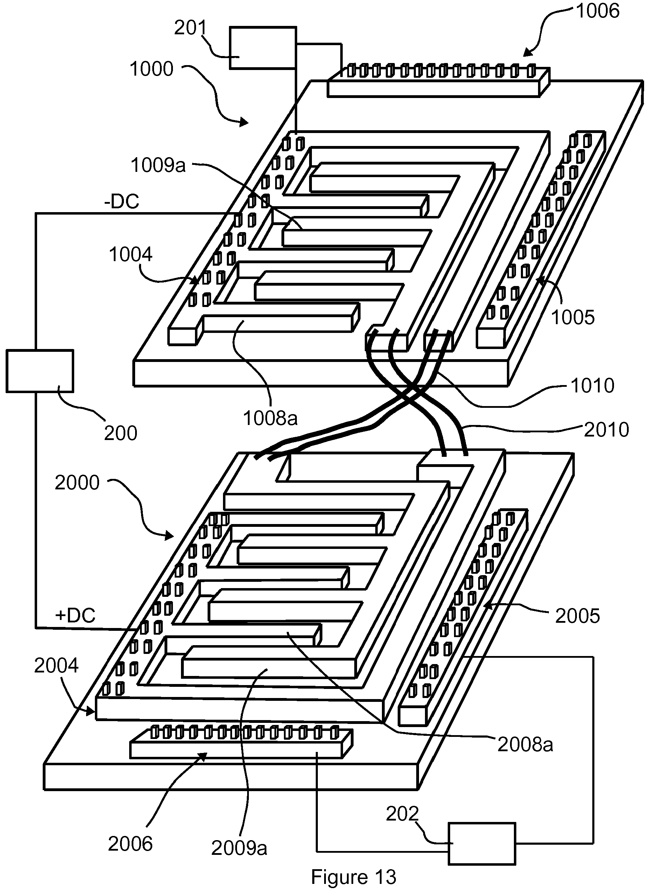

Pour former le convertisseur d'énergie électrique, il peut aussi être utilisé des transistors intégrés à des composants électroniques distincts chacun ayant une électrode connectée à un potentiel continu différent, et chaque puce ou composant électronique intégrant un demi-composant capacitif, les demi-composants capacitif de deux composants électroniques étant ensuite connectés pour former le composant capacitif. Ainsi, selon une alternative au composant électronique intégrant deux transistors, on va chercher à former un dispositif pour la conversion d'énergie électrique (ou onduleur), ci-après nommé dispositif, en utilisant deux composants électroniques tels que décrits précédemment et chacun muni d'un transistor. Comme illustré en figures 12 et 13, l'invention est aussi relative à un tel dispositif comprenant un premier composant électronique 1000 tel que décrit précédemment (et donc muni d'un transistor correspondant) et un deuxième composant électronique 2000 tel que décrit précédemment (et donc muni d'un transistor correspondant). Dans le domaine, le premier composant électronique peut être assimilé à un composant dit « low-side » et le deuxième composant électronique peut être assimilé à un composant dit « high-side ». La première électrode 1032 du transistor du premier composant électronique 1000 (notamment située sous la première borne de connexion électrique 1004 du premier composant électronique 1000) est une électrode de source du transistor du premier composant électronique 1000, et est destinée à être reliée électriquement à un potentiel négatif (-DC) à courant continu d'une alimentation électrique 200 du dispositif. La deuxième électrode 1033 (notamment située sous la deuxième borne de connexion électrique 1005 du premier composant électronique 1000) du transistor 1003 du premier composant électronique 1000 est une électrode de drain du transistor du premier composant électronique 1000, et est destinée à être reliée électriquement à une sortie en courant alternatif du dispositif (notamment via la deuxième borne de connexion électrique 1005 du premier composant électronique 1000). L'électrode de commande 1031 du transistor 1003 du premier composant électronique 1000 est une électrode de grille du transistor 1003 du premier composant 1000, l'électrode de commande 1031 étant reliée électriquement à la troisième borne de connexion 1006 du premier composant électronique 1000. La première électrode 2032 du transistor 2003 du deuxième composant électronique 2000 est une électrode de drain du transistor 2003 du deuxième composant électronique 2000, et est destinée à être reliée électriquement à un potentiel positif (+DC) à courant continu de l'alimentation électrique 200 du dispositif, notamment via la première borne 2004 de connexion électrique du deuxième composant électronique 2000, on comprend alors que la première borne 2004 du deuxième composant électronique 2000 est en contact électrique avec la première électrode 2032 du transistor du deuxième composant électronique. La deuxième électrode 2033 du transistor 2003 du deuxième composant électronique 2000 est une électrode de source du transistor 2003 du deuxième composant électronique 2000, et est destinée à être reliée électriquement à la sortie en courant alternatif, notamment via la deuxième borne de connexion électrique 2005 du deuxième composant électronique 2000. L'électrode de commande 2031 du transistor 2003 du deuxième composant électronique 2000 est une électrode de grille du transistor du deuxième composant électronique 2000 en contact avec la troisième borne de connexion 2006. Les doigts 1008a du premier ensemble de doigts du premier composant électronique 1000 sont reliés électriquement aux doigts 2009a du deuxième ensemble de doigts du deuxième composant électronique 2000 par exemple en utilisant au moins un fil électriquement conducteur 1010 reliant les premier et deuxième composants électroniques. Les doigts 1009a du deuxième ensemble de doigts du premier composant électronique 1000 sont reliés électriquement aux doigts 2008a du premier ensemble de doigts du deuxième composant électronique 2000 par exemple en utilisant au moins un fil électriquement conducteur 2010 reliant les premier et deuxième composants électroniques. Ici, le composant capacitif comporte les doigts des premier et deuxième ensembles de doigts des premier et deuxième composants électroniques. On peut alors dire que dispositif pour la conversion d'énergie électrique comporte le composant capacitif.

Sur la figure 13, il est représenté schématiquement l'alimentation électrique 200 en courant continu que le dispositif peut comporter. Cette alimentation 200 est reliée, d'une part, à la première borne de connexion électrique 1004 du premier composant électronique 1000 pour y appliquer un potentiel négatif de courant continu, et, d'autre part, à la première borne de connexion électrique 2004 du deuxième composant électronique 2000 pour y appliquer un potentiel positif de courant continu. Le dispositif peut aussi comporter un système de contrôle 201, 202 par transistor connecté, pour chaque transistor, à la grille dudit transistor et à la source dudit transistor. Par ailleurs, bien que cela ne soit pas représenté pour des raisons de clarté une couche en matériau de passivation tel que décrit précédemment peut être formée pour chaque composant électronique pour recouvrir les doigts et remplir les espaces entre les doigts. Notamment, le dispositif comporte la sortie en courant alternatif reliée aux deuxièmes bornes 1005 et 2005 des premier et deuxième composants électroniques 1000, 2000.

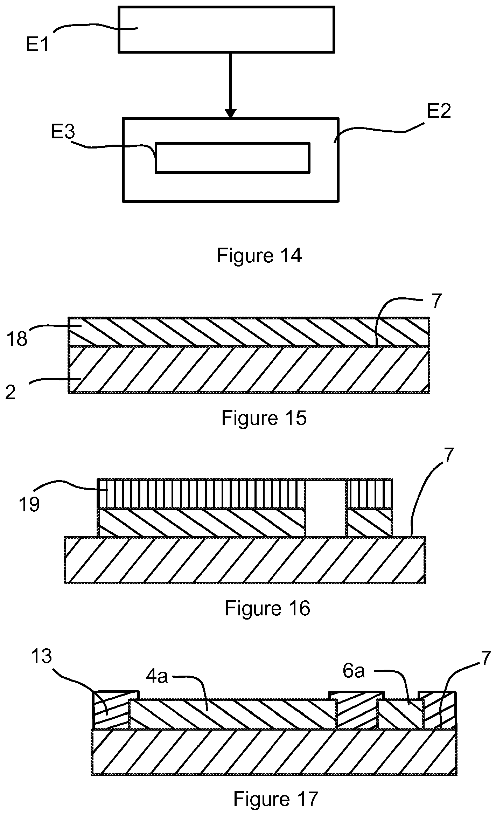

L'invention est aussi relative à un procédé de fabrication d'un composant électronique, notamment tel que décrit précédemment. En ce sens, le procédé de fabrication du composant électronique peut comporter une étape de fourniture E1 (Figure 14) de la partie 2 du composant électronique 1 comportant/intégrant le transistor 3 muni de l'électrode de commande 31 et des première et deuxième électrodes 32, 33 (figure 3). Ladite partie 2 du composant électronique 1 comporte la face de connexion 7 destinée à permettre la formation de bornes de connexion électrique du composant électronique (notamment des première, deuxième et troisième bornes de connexion électrique). Par ailleurs, le procédé comporte aussi (figures 2 et 14) une étape de formation E2 des première, deuxième et troisième bornes de connexion électrique 4, 5, 6 dudit composant électronique au niveau de la face de connexion 7 (c'est-à-dire sur la face de connexion) de telle sorte que la première borne de connexion électrique 4 soit reliée électriquement à, et notamment formée de sorte à être en contact avec, la première électrode 32 du transistor 3, que la deuxième borne de connexion électrique 5 soit reliée électriquement à, et notamment formée de sorte à être en contact avec, la deuxième électrode 33 du transistor 3, et que la troisième borne de connexion électrique 6 soit reliée électriquement à, et notamment formée de sorte à être en contact avec, l'électrode de commande 31 du transistor 3. Par relié électriquement, on entend notamment la présence d'un lien électrique. Par ailleurs, le procédé comporte une étape de formation E3 du premier ensemble 8 de doigts 8a électriquement conducteurs et du deuxième ensemble 9 de doigts 9a électriquement conducteurs du composant électronique de telle sorte que, notamment au terme du procédé de fabrication :

- les doigts 8a, 9a du premier ensemble 8 de doigts et du deuxième ensemble 9 de doigts sont interdigités, au niveau de la face de connexion 7, pour former ladite au moins une partie d'un composant capacitif, et
- les doigts 8a du premier ensemble 8 de doigts sont reliés électriquement à la première borne de connexion électrique 4.

De préférence, cette étape de formation E3 du premier ensemble de doigts et du deuxième ensemble de doigts est réalisée au cours de l'étape de formation E2 des bornes de connexion électrique. Autrement dit, on va utiliser des étapes technologiques de microélectronique pour former simultanément au moins une partie de chacune des bornes de connexion électriques 4, 5, 6 et au moins une partie de chacun des doigts 8a, 9a des premier et deuxième ensembles de doigts. Ceci permet de former les doigts au plus près des bornes de connexion tout en permettant d'utiliser des caractéristiques de dépôt ou de croissance adaptées selon un masque pour avoir un bon alignement des doigts 8a, 9b. D'autre part, cela permet aussi de limiter le nombre d'étapes technologiques. Autrement dit, l'étape de formation E2 des première, deuxième et troisième bornes de connexion électrique et l'étape de formation E3 du premier ensemble de doigts et du deuxième ensemble de doigts sont telles qu'au moins une partie 4a de la première borne de connexion électrique 4, et au moins une partie de chacun des doigts du premier ensemble de doigts, et de préférence au moins une partie de chacun des doigts du deuxième ensemble de doigts et des parties des deuxième et troisième bornes de connexion électrique, sont formés simultanément. En particulier, cette formation simultanée est telle que ladite au moins une partie de chaque doigt du premier ensemble de doigts forme une continuité de matière avec ladite au moins une partie de la première borne de connexion électrique.

Selon une première réalisation du procédé, les étapes de formation E2 et E3 sont telles que ladite au moins une partie 4a de la première borne de connexion électrique 4 et ladite au moins une partie de chacun des doigts du premier ensemble de doigts sont formés simultanément par :

- une étape de formation d'une couche électriquement conductrice 18 - par exemple par dépôt d'un matériau métallique (figure 15) - sur la face de connexion 7, puis
- une étape de gravure de ladite couche électriquement conductrice 18, notamment selon un masque de gravure 19 (figure 16) prédéfini formé sur la couche électriquement conductrice 18 après sa formation.

La gravure s'arrête notamment lorsque la face de connexion 7 est atteinte (figure 16). Le masque de gravure prédéfini permet notamment que ladite au moins une partie de chacun des doigts du deuxième ensemble de doigts soit raccordée à ladite au moins une partie 4a de la première borne de connexion 4 tout en formant une continuité de matière.

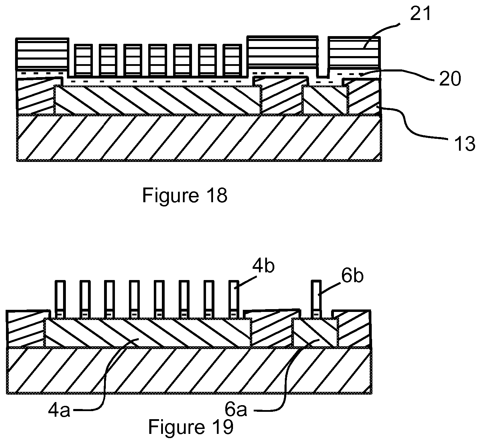

Dans le cas où les doigts interdigités sont seulement formés au niveau des organes électriquement conducteurs 4a, 5a, 6a (figures 2, 9, 10 et 13), l'étape de gravure de la couche électriquement conductrice 18 est telle que : un organe électriquement conducteur 4a, 5a, 6a est formé pour chacune des première, deuxième et troisième bornes de connexion électrique 4, 5, 6 ; et les doigts 8a du premier ensemble 8 de doigts forment, avec l'organe électriquement conducteur de la première borne de connexion, une continuité de matière. Autrement dit, l'étape de gravure de la couche électriquement conductrice 18 permet de former de manière simultanée les organes 4a, 5a, 6a des première à troisième bornes de connexion 4, les doigts 8a du premier ensemble de doigts alors raccordés audit organe 4a de la première borne 4 de connexion électrique et les doigts 9a du deuxième ensemble de doigts de préférence raccordés au bus de raccordement 9b des doigts du deuxième ensemble de doigts évoqué ci-avant et notamment délimité lui aussi par l'étape de gravure de la couche électriquement conductrice. Après cela, une couche d'un matériau diélectrique, (par exemple la couche de passivation 13 de la figure 17) peut être formée pour combler les espaces entre les doigts, et notamment de sorte à les recouvrir ainsi que les organes des bornes de connexion, le matériau utilisé peut être le matériau diélectrique décrit ci-avant pour améliorer la capacité. Cette couche de passivation 13 peut aussi combler les espaces entre les organes électriquement conducteurs pour que l'isolation électrique du futur composant électronique soit convenable. Enfin, le cas échéant, les piliers peuvent être formés en particulier après avoir ouvert de manière adaptée la couche de passivation 13 comme sur la figure 17 où on libère des sommets des organes électriquement conducteurs 4a, 6a avant de déposer une couche de croissance 20 (figure 18) puis de former un masque de croissance 21 sur la couche de croissance 20. Le masque de croissance 21 peut être formé par lithographie avant de faire croitre les piliers par exemple en cuivre depuis le fond du masque de croissance à 21 partir de la couche de croissance 20. Ensuite, le masque de croissance 21 est retiré et les parties de la couche de croissance 20 révélées par le retrait du masque de croissance peuvent être retirées (figure 19) d'où il résulte qu'une base en matériau de la couche de croissance est interposée entre chaque pilier 4b, 6b et son organe électriquement conducteur 4a, 6a associé.

Selon une deuxième réalisation, l'étape de formation des première, deuxième et troisième bornes de connexion électrique comporte une étape de réalisation, pour chacune des première, deuxième et troisième bornes de connexion électrique 4, 5, 6, d'un organe électriquement conducteur 4a, 5a, 6a surmonté de piliers 4b, 5b, 6b électriquement conducteurs, par exemple à la manière de ce qui est illustré en figure 2. Par ailleurs, au moins une partie de chacun des doigts du premier et du deuxième ensembles de doigts et les piliers sont formés simultanément par croissance, de préférence de cuivre, selon un masque 21 de croissance (figure 18) dont le motif permet de réaliser des piliers 4b formant ladite au moins une partie de la première borne de connexion électrique 4, notamment en cuivre, et de lier électriquement chaque doigt 8a du premier ensemble 8 de doigts à au moins un pilier 4b de la première borne de connexion électrique 4, notamment en formant pour chaque doigt 8a une continuité de matière comportant ledit doigt 8a et un pilier 4b correspondant de la première borne de connexion électrique 4. La croissance, notamment de cuivre, est donc réalisée depuis le masque de croissance.

Selon une variante de cette deuxième réalisation (figure 7), les étapes de formation des première à troisième bornes de connexion et des premier et deuxième ensembles de doigts peuvent être mises en œuvre par :

- une étape de formation simultanée des organes électriquement conducteurs des première à troisième bornes de connexion électrique et d'une première partie 81, 91 longitudinale de chacun des doigts des premier et deuxième ensembles de doigts comportant :

  ◦ une étape de formation d'une couche électriquement conductrice sur la face de connexion, puis
  ◦ une étape de gravure de ladite couche électriquement conductrice,

- une étape de croissance simultanée des piliers et d'une deuxième partie longitudinale 82, 92 de chacun des doigts des premier et deuxième ensembles de doigts selon le masque de croissance. Pour chaque doigt, la première partie longitudinale 81, 91 du doigt se retrouve interposée entre la face de connexion 7 et la deuxième partie longitudinale 82, 92 dudit doigt.

Selon la variante dans laquelle seules des parties de chacun des doigts sont formées lors de la formation et de la gravure de la couche électriquement conductrice, on va compléter les doigts lors de la formation des piliers. Pour cela, une couche de passivation 13 est déposée après gravure de la couche électriquement conductrice (figure 17) et est ouverte pour rendre accessible les sommets des organes électriquement conducteurs et des parties de chacun des doigts des premier et deuxième ensembles de doigts formées simultanément aux organes 4a, 5a, 6a. Ici les sommets correspondent à des faces distales de la face de connexion 7. Ensuite, comme décrit ci-avant, la couche de croissance 20 puis le masque 21 sont formés en vue de permettre la croissance des piliers et la croissance de la deuxième partie de chacun des doigts du premier ensemble et du deuxième ensemble de doigts au-dessus d'une première partie correspondante de doigt.

La formation des doigts interdigités simultanément à la formation des organes électriquement conducteurs des première, deuxième et troisième bornes de connexion électrique est plus simple à mettre en œuvre car les dimensions des motifs obtenus sont proches des motifs classiquement utilisés en microélectronique, il est donc ensuite facile de déposer un matériau diélectrique pour passiver les bornes de connexion électriques et combler les espaces entre les doigts. Par ailleurs, la formation des doigts interdigités simultanément aux organes n'empêche pas par la suite la croissance de piliers en cuivre au sommet des bases pour prévoir ensuite une interconnexion de type « puce retournée » ou « flip-chip » en langue anglaise.

La formation des doigts 8a, 9a simultanément à la formation des piliers permet d'augmenter les surfaces en regard des doigts adjacents pour optimiser la valeur de la capacité du composant capacitif.

L'homme du métier est à même de mettre en œuvre les différentes étapes technologies permettant de former le composant électronique tel que décrit sur la base du procédé décrit ci-avant.

Dans le cadre du procédé, l'étape de formation de la couche électriquement conductrice 18 peut être réalisée sur la partie 2 (figure 15), notamment sur la face de connexion 7, par dépôt d'un alliage de AlSi (c'est-à-dire aluminium-silicium par exemple composé de 99% at d'aluminium et de 1% at de Silicium, avec % at représentant le pourcentage atomique) d'une épaisseur comprise entre $1\mu m$ et $5\mu m$ (et de préférence égale à $4\mu m$) ou alternativement par dépôt de cuivre avec une finition d'or pour éviter l'oxydation du cuivre, ou encore par dépôt d'aluminium. L'étape de gravure (figure 16) de la couche électriquement conductrice 18 permet de délimiter les organes électriquement conducteurs 4a, 6a des bornes de connexion électrique et le cas échéant les doigts (ou des parties de ces doigts) des premier et deuxième ensembles de doigts. L'étape de gravure de la couche électriquement conductrice 18 peut être mise en œuvre après formation d'un masque 19 par lithographie sur la couche électriquement conductrice 18, notamment en utilisant une résine photosensible, dont les ouvertures permettent de délimiter les portions à retirer de la couche électriquement conductrice 18 (figure 16). Après gravure de la couche électriquement conductrice 18, le masque 19 est retiré, et l'on obtient les organes électriquement conducteurs 4a, 5a, 6a et, le cas échéant des doigts ou des parties de doigts 8a, 9a à l'image des figures 2, 7, 8, 9 et 10. Ensuite, une couche de passivation 13 (figure 17), notamment en matériau diélectrique - ou matériau de passivation - tel que décrit précédemment est déposée sur les organes électriquement conducteurs, la face de connexion et le cas échéant les doigts ou les parties de doigts. Cette couche de passivation 13 présente un rôle d'isolation électrique des bornes de connexion électriques entre elles, et permet d'améliorer la valeur de la capacité comme on l'a décrit ci-avant en remplissant les espaces entre les doigts adjacents. Cette couche de passivation 13 est ensuite ouverte (figure 17) au niveau des organes électriquement conducteurs 4a, 5a, 6a pour les rendre accessibles. Si les doigts ont été formés simultanément aux organes électriquement conducteurs, le procédé peut s'arrêter après ouverture de la couche de passivation 13. Pour former les piliers 4b, 6b (figures 18 et 19), après ouverture de la couche de passivation 13 une couche de croissance 20 est déposée de sorte à recouvrir la couche de passivation 13 et les sommets des organes des bornes de connexion rendus accessibles. La couche de croissance peut comporter du titane et du cuivre, on dépose d'abord le titane de préférence selon une épaisseur de 100nm, puis le cuivre de préférence selon une épaisseur de 200nm, la couche de croissance est alors formée par deux couches successives respectivement en titane et en cuivre. Ensuite, un masque 21 de croissance pour la formation des piliers est formé sur la couche de croissance 20 (figure 18) de sorte à délimiter une pluralité d'ouvertures au-dessus de chacun des sommets des organes électriquement conducteurs. Le masque de croissance peut être une résine photosensible adaptée. Le cas échéant, le masque de croissance 21 présente aussi des ouvertures permettant de former les doigts (ou des parties de doigts) correspondants. Après formation des ouvertures du masque de croissance 21, la croissance des piliers et le cas échéant des doigts ou des parties de doigts, est réalisée par exemple par ECD pour l'anglais « Electro Chemical Déposition » depuis les parties libres de la couche de croissance 20. Enfin, le masque de croissance 21 est retiré (figure 19), notamment par gravure sélective de ce dernier, puis les portions de la couche de croissance 20 rendues accessibles par le retrait du masque de croissance 21 sont retirées, notamment par gravure sélective du, ou des, matériau(x) utilisé(s) pour former la couche de croissance. Comme évoqué des plots en matériau de brasure peuvent aussi être formés au sommet de chaque pilier. L'homme du métier sera à même d'adapter les étapes technologiques décrites ci-dessus pour réaliser les différents modes de réalisation du composant électronique tel que décrit.

On a évoqué que les piliers étaient destinés à être utilisés pour par exemple réaliser de la connexion de type « flip Chip ». En ce sens, le composant électronique est préférentiellement tel que le sommet des piliers forme une saillie par rapport au reste du composant électronique pour faciliter sa connexion. En ce sens, lorsque les doigts du premier ensemble de doigts comportent une première partie en continuité de l'organe 4 et une deuxième partie en continuité de piliers correspondant, il est possible de graver une partie des doigts pour limiter leur hauteur par rapport à la face de connexion de sorte à conserver la saillie souhaitée au niveau du sommet des piliers formés au-dessus de l'organe 4a pour permettre de connecter des composants extérieurs au composant électronique via les sommets des piliers. Ceci est aussi valable pour le mode de réalisation de la figure 8.

On comprend de ce qui a été décrit ci-avant que la présente invention permet de former au moins une partie d'un composant capacitif, ou condensateur, en surface du composant électronique qui est notamment un composant électronique de puissance de type GaN. Comme on l'a vu aussi précédemment, les doigts interdigités sont formés en utilisant des étapes technologiques présentes au cours de la formation du composant électronique dépourvu de composant capacitif. En ce sens, il est possible de former ladite au moins une partie du composant capacitif au plus près des bornes de connexion et en utilisant des étapes technologiques compatibles avec la formation des composants électroniques. Il en résulte que le surcoût est limité et très inférieur à celui lié à la formation d'un composant capacitif additionnel indépendant du composant électronique logeant le ou les transistors.

En proposant de rapprocher le composant capacitif du transistor, la présente invention permet de réduire les pertes en commutation résultant de la réduction des surtensions lors de commutations et de l'accélération des commutations. Par ailleurs, cela permet aussi de réduire le volume global des composants de filtrage utilisant le composant électronique tel que décrit.

Concernant le procédé, les techniques de dépôt et de gravure sont bien connues de l'homme du métier pour les matériaux cités.

Tout ce qui a été dit en relation avec le composant électronique peut s'appliquer au procédé de fabrication de ce composant électronique et inversement.

En particulier, dans le cadre du procédé de fabrication, l'étape de formation des première, deuxième et troisième bornes de connexion électrique 4, 5, 6 peut comporter une étape de réalisation, au moins pour la première borne de connexion électrique 4 et notamment pour chacune des première, deuxième et troisième bornes de connexion électrique, d'un organe électriquement conducteur surmonté de piliers électriquement conducteurs.

On comprend de tout ce qui a été dit ci-dessus qu'une continuité de matière au sens de la présente description peut comporter, ou être formée par du cuivre, ou l'alliage de AlSi tel que décrit, ou de l'aluminium. Un doigt ou une partie de doigt dans le cadre de la présente description peut comporter, ou être formé par, le cas échéant, du cuivre, un alliage de AlSi, ou de l'aluminium.

## Revendications

1. Composant électronique (1) comprenant une partie (2) intégrant un transistor (3) muni d'une électrode de commande (31) et de première et deuxième électrodes (32, 33), le composant électronique (1) comportant des première, deuxième et troisième bornes de connexion électrique (4, 5, 6) s'étendant sur une face de connexion (7) de ladite partie (2) intégrant le transistor (3), la première borne de connexion électrique (4) étant en lien électrique avec la première électrode (32), la deuxième borne de connexion électrique (5) étant en lien électrique avec la deuxième électrode (33) et la troisième borne de connexion électrique (6) étant en lien électrique avec l'électrode de commande (31), le composant électronique (1) comportant un premier ensemble (8) de doigts électriquement conducteurs et un deuxième ensemble (9) de doigts électriquement conducteurs, les doigts (8a, 9a) des premier et deuxième ensembles (8, 9) de doigts étant interdigités, au niveau de la face de connexion (7), pour former au moins une partie d'un composant capacitif, et les doigts (8a) du premier ensemble (8) de doigts étant reliés électriquement à la première borne de connexion électrique (4), la première borne de connexion électrique (4) comportant un organe (4a) électriquement conducteur s'étendant sur la face de connexion (7), **caractérisé en ce que** la première borne de connexion électrique (4) comporte une pluralité de piliers (4b) reliés électriquement à l'organe (4a) agencé entre les piliers (4b) et la face de connexion (7).

2. Composant selon la revendication précédente, **caractérisé en ce que** les doigts (8a, 9a) du premier ensemble (8) de doigts et du deuxième ensemble (9) de doigts s'étendent selon leur longueur parallèlement à la face de connexion (7).

3. Composant selon l'une quelconque des revendications précédentes, **caractérisé en ce qu'**au moins une partie de chaque doigt (8a) du premier ensemble de doigts (8) forme une continuité de matière avec au moins une partie de la première borne de connexion électrique (4).

4. Composant selon l'une quelconque des revendications précédentes, **caractérisé en ce que** :

   - les doigts (8a) du premier ensemble de doigts (8) forment une continuité de matière avec l'organe (4a) électriquement conducteur de la première borne de connexion électrique (4), ou
   - chaque doigt (8a) du premier ensemble de doigts (8) comporte une première partie longitudinale (81) et une deuxième partie longitudinale (82), la première partie (81) étant agencée entre la deuxième partie (82) et la face de connexion (7), lesdites premières parties formant, avec l'organe (4a), une première continuité de matière, et lesdites deuxièmes parties (82) formant chacune, avec un pilier (4b) correspondant de la première borne de connexion électrique (4), une deuxième continuité de matière, ou
   - chaque doigt (8a) du premier ensemble de doigts forme une continuité de matière avec au moins un pilier (4b) de la première borne de connexion (4).

5. Composant selon l'une quelconque des revendications 1 à 3, **caractérisé en ce que** les doigts (8a) du premier ensemble (8) de doigts forment une continuité de matière avec l'organe (4a) électriquement conducteur de la première borne de connexion électrique (4), et **en ce que** le composant électronique comporte un troisième ensemble (11) de doigts (11a) électriquement conducteurs et un quatrième ensemble (12) de doigts (12a) électriquement conducteurs, les doigts (11a, 12a) du troisième ensemble (11) de doigts et du quatrième ensemble (12) de doigts étant interdigités, chaque doigt (12a) du quatrième ensemble (12) de doigts formant, avec au moins un pilier (4b) de la première borne (4) de connexion électrique, une continuité de matière, et **en ce que** :

   - chaque doigt (8a) du premier ensemble (8) de doigts comporte une partie longitudinale agencée entre une partie longitudinale d'un doigt (11a) du troisième ensemble (11) de doigts et la face de connexion (7),
   - chaque doigt (9a) du deuxième ensemble (9) de doigts comporte une partie longitudinale agencée entre une partie longitudinale d'un doigt (12a) du quatrième ensemble (12) de doigts et la face de connexion (7),
   - les doigts (8a) du premier ensemble (8) de doigts sont reliés électriquement aux doigts (12a) du quatrième ensemble (12) de doigts,
   - les doigts (9a) du deuxième ensemble (9) de doigts sont reliés électriquement aux doigts 11a) du troisième ensemble (11) de doigts.

**6.** Composant selon l'une quelconque des revendications précédentes, **caractérisé en ce que** les doigts (8a, 9a) du premier ensemble (8) de doigts et du deuxième ensemble (9) de doigts sont interdigités entre la face de connexion (7) et un plan situé à distance de la face de connexion (7) et passant par les première, deuxième et troisième bornes de connexion électrique (4, 5, 6).

**7.** Composant selon l'une quelconque des revendications précédentes, **caractérisé en ce que** les première, deuxième et troisième bornes de connexion électrique (4, 5, 6) sont agencées à la périphérie de la face de connexion (7) d'où il résulte la présence d'un volume en regard de la face de connexion (7) au sein duquel sont agencés les doigts (8a, 9a) des premier et deuxième ensemble (8, 9) de doigts.

**8.** Composant selon l'une quelconque des revendications précédentes, **caractérisé en ce que** ledit transistor (3) est un premier transistor (3) dont la première électrode (32) est une électrode de source du premier transistor (3), la deuxième électrode (33) est une électrode de drain du premier transistor (3), et l'électrode de commande (31) du premier transistor (3) est une électrode de grille du premier transistor (3), et **en ce que** le composant électronique comporte :

- un transistor additionnel (15) formant un deuxième transistor muni d'une électrode de grille (151), d'une électrode de source (152) et d'une électrode de drain (153),
- une quatrième borne de connexion électrique (16) s'étendant sur la face de connexion (7) et reliée électriquement à l'électrode de grille (151) du deuxième transistor (15),
- une cinquième borne de connexion électrique (17) s'étendant sur la face de connexion (7) et étant reliée électriquement à l'électrode de drain (153) du deuxième transistor (15), les doigts (9a) du deuxième ensemble (9) de doigts étant reliés électriquement à la cinquième borne de connexion électrique (17),

l'électrode de source (152) du deuxième transistor (15) étant reliée électriquement à la deuxième borne de connexion électrique (5), la première borne de connexion électrique (4) étant destinée à être reliée à un potentiel négatif à courant continu d'une alimentation électrique, et la cinquième borne de connexion électrique (17) étant destinée à être reliée à un potentiel positif à courant continu de l'alimentation électrique d'où il résulte que la deuxième borne de connexion électrique (5) forme une sortie apte à fournir un courant alternatif.

**9.** Dispositif pour la conversion d'énergie électrique, **caractérisé en ce qu'**il comprend un premier composant électronique (1000) selon l'une quelconque des revendications 1 à 7 et un deuxième composant électronique (2000) selon l'une quelconque des revendications 1 à 7, et **en ce que** :

- la première électrode (1032) du transistor (1003) du premier composant électronique (1000) est une électrode de source, et est destinée à être reliée électriquement à un potentiel négatif à courant continu d'une alimentation électrique (200) du dispositif,
- la deuxième électrode (1033) du transistor (1003) du premier composant électronique (1000) est une électrode de drain, et est destinée à être reliée électriquement à une sortie en courant alternatif du dispositif,
- l'électrode de commande (1031) du transistor (1003) du premier composant électronique (1000) est une électrode de grille,
- la première électrode (2032) du transistor (2003) du deuxième composant électronique (2000) est une électrode de drain, et est destinée à être reliée électriquement à un potentiel positif à courant continu de l'alimentation électrique (200) du dispositif,
- la deuxième électrode (2033) du transistor (2003) du deuxième composant électronique (2000) est une électrode de source, et est destinée à être reliée à la sortie en courant alternatif,
- l'électrode de commande (2031) du transistor (2003) du deuxième composant électronique (2000) est une électrode de grille,
- les doigts (1008a) du premier ensemble (1008) de doigts du premier composant électronique (1000) sont reliés électriquement aux doigts (2009a) du deuxième ensemble de doigts du deuxième composant électronique (2000),
- les doigts (1009a) du deuxième ensemble de doigts du premier composant électronique (1000) sont reliés électriquement aux doigts (2008a) du premier ensemble de doigts du deuxième composant électronique (2000).

**10.** Procédé de fabrication d'un composant électronique selon la revendication 1, ledit procédé comportant :

- une étape de fourniture (E1) de la partie (2) du composant électronique (1) comportant le transistor (3) muni de l'électrode de commande (31) et des première et deuxième électrodes (32, 33), ladite partie (2) du composant électronique (1) comportant la face de connexion (7) destinée à permettre la formation de bornes de connexion électrique du composant électronique,

- une étape de formation (E2) des première, deuxième et troisième bornes de connexion électrique (4, 5, 6) dudit composant électronique (1) au niveau de la face de connexion (7) de telle sorte que :

  ◦ la première borne de connexion électrique (4) soit reliée électriquement à la première électrode (32) du transistor (3),
  ◦ la deuxième borne de connexion électrique (5) soit reliée électriquement à la deuxième électrode (33) du transistor (3) et,
  ◦ la troisième borne de connexion électrique (6) soit reliée électriquement à l'électrode de commande (31) du transistor (3),

- une étape de formation (E3) du premier ensemble (8) de doigts (8a) électriquement conducteurs et du deuxième ensemble (9) de doigts (9a) électriquement conducteurs de telle sorte que :

  ◦ les doigts (8a, 9a) du premier ensemble (8) de doigts et du deuxième ensemble (9) de doigts soient interdigités, au niveau de la face de connexion (7), pour former ladite au moins une partie d'un composant capacitif, et
  ◦ les doigts (8a) du premier ensemble (8) de doigts soient reliés électriquement à la première borne de connexion électrique (4).

11. Procédé selon la revendication précédente, **caractérisé en ce que** l'étape de formation (E2) des première, deuxième et troisième bornes de connexion électrique (4, 5, 6) et l'étape de formation (E3) du premier ensemble (8) de doigts (8a) électriquement conducteurs et du deuxième ensemble (9) de doigts (9a) électriquement conducteurs sont telles qu'au moins une partie (4a) de la première borne de connexion électrique (4), et au moins une partie de chacun des doigts (8a) du premier ensemble (8) de doigts sont formés simultanément.

12. Procédé selon la revendication précédente, **caractérisé en ce que** ladite au moins une partie (4a) de la première borne de connexion électrique (4) et ladite au moins une partie de chacun des doigts (8a) du premier ensemble (8) de doigts sont formées simultanément par :

  - une étape de formation d'une couche électriquement conductrice (18) sur la face de connexion (7), puis
  - une étape de gravure de ladite couche électriquement conductrice (18).

13. Procédé selon la revendication précédente, **caractérisé en ce que** l'étape de gravure de la couche électriquement conductrice (18) est telle que :

  - un organe électriquement conducteur (4a, 5a, 6a) est formé pour chacune des première, deuxième et troisième bornes de connexion (4, 5, 6), et
  - les doigts du premier ensemble de doigts forment, avec l'organe de la première borne de connexion électrique, une continuité de matière.

14. Procédé selon l'une quelconque des revendications 10 à 11, **caractérisé en ce que** l'étape de formation des première, deuxième et troisième bornes de connexion électrique (4, 5, 6) comporte une étape de réalisation, pour chacune des première, deuxième et troisième bornes de connexion électrique, d'un organe électriquement conducteur surmonté de piliers électriquement conducteurs, et **en ce qu'**au moins une partie de chacun des doigts (8a, 9a) du premier et du deuxième ensembles (8,9) de doigts et les piliers sont formés simultanément par croissance selon un masque (21) de croissance.

**Patentansprüche**

1. Elektronisches Bauteil (1), das einen Teil (2) umfasst, der einen Transistor (3) beinhaltet, welcher mit einer Steuerelektrode (31) und einer ersten und einer zweiten Elektrode (32, 33) ausgestattet ist, wobei das elektronische Bauteil (1) eine erste, eine zweite und eine dritte elektrische Anschlussklemme (4, 5, 6) umfasst, die sich auf einer Anschlussfläche (7) des Teils (2), der den Transistor (3) beinhaltet, erstrecken, wobei die erste elektrische Anschlussklemme (4) mit der ersten Elektrode (32) in elektrischer Verbindung steht, die zweite elektrische Anschlussklemme (5) mit der zweiten Elektrode (33) in elektrischer Verbindung steht, und die dritte elektrische Anschlussklemme (6) mit der Steuerelektrode (31) in elektrischer Verbindung steht, wobei das elektronische Bauteil (1) einen ersten Satz (8) elektrisch leitender Finger und einen zweiten Satz (9) elektrisch leitender Finger umfasst, wobei die Finger (8a, 9a) des ersten und des zweiten Fingersatzes (8, 9) im Bereich der Anschlussfläche (7) ineinandergreifen, um mindestens einen Teil eines kapazitiven Bauteils zu bilden, und wobei die Finger (8a) des ersten Fingersatzes (8) elektrisch mit der ersten elektrischen Anschlussklemme (4) verbunden sind, wobei die erste elektrische Anschlussklemme (4) ein elektrisch leitendes Glied (4a) umfasst, das sich auf der Anschlussfläche (7) erstreckt, **dadurch gekennzeichnet, dass** die erste elektrische Anschlussklemme (4) eine Vielzahl von Pfeilern (4b) umfasst, die elektrisch mit dem zwischen den Pfeilern (4b) und der Anschlussfläche (7) angeordneten Glied (4a) verbunden sind.

2. Bauteil nach dem vorstehenden Anspruch, **dadurch gekennzeichnet, dass** sich die Finger (8a, 9a) des ersten Fingersatzes (8) und des zweiten Fingersatzes (9) ihrer Länge nach parallel zur Anschlussfläche (7) erstrecken.

3. Bauteil nach einem der vorstehenden Ansprüche, **dadurch gekennzeichnet, dass** mindestens ein Teil jedes Fingers (8a) des ersten Fingersatzes (8) mit mindestens einem Teil der ersten elektrischen Anschlussklemme (4) einen Stoffschluss bildet.

4. Bauteil nach einem der vorstehenden Ansprüche, **dadurch gekennzeichnet, dass**:

   - die Finger (8a) des ersten Fingersatzes (8) mit dem elektrisch leitenden Glied (4a) der ersten elektrischen Anschlussklemme (4) einen Stoffschluss bilden, oder
   - jeder Finger (8a) des ersten Fingersatzes (8) einen ersten Längsteil (81) und einen zweiten Längsteil (82) umfasst, wobei der erste Teil (81) zwischen dem zweiten Teil (82) und der Anschlussfläche (7) angeordnet ist, wobei die ersten Teile mit dem Glied (4a) einen ersten Stoffschluss bilden, und die zweiten Teile (82) jeweils mit einem entsprechenden Pfeiler (4b) der ersten elektrischen Anschlussklemme (4) einen zweiten Stoffschluss bilden, oder
   - jeder Finger (8a) des ersten Fingersatzes mit mindestens einem Pfeiler (4b) der ersten Anschlussklemme (4) einen Stoffschluss bildet.

5. Bauteil nach einem der Ansprüche 1 bis 3, **dadurch gekennzeichnet, dass** die Finger (8a) des ersten Fingersatzes (8) mit dem elektrisch leitenden Glied (4a) der ersten elektrischen Anschlussklemme (4) einen Stoffschluss bilden, und dadurch, dass das elektronische Bauteil einen dritten Satz (11) elektrisch leitender Finger (11a) und einen vierten Satz (12) elektrisch leitender Finger (12a) umfasst, wobei die Finger (11a, 12a) des dritten Fingersatzes (11) und des vierten Fingersatzes (12) ineinandergreifen, wobei jeder Finger (12a) des vierten Fingersatzes (12) mit mindestens einem Pfeiler (4b) der ersten elektrischen Anschlussklemme (4) einen Stoffschluss bildet, und dadurch, dass:

   - jeder Finger (8a) des ersten Fingersatzes (8) einen Längsteil umfasst, der zwischen einem Längsteil eines Fingers (11a) des dritten Fingersatzes (11) und der Anschlussfläche (7) angeordnet ist,
   - jeder Finger (9a) des zweiten Fingersatzes (9) einen Längsteil umfasst, der zwischen einem Längsteil eines Fingers (12a) des vierten Fingersatzes (12) und der Anschlussfläche (7) angeordnet ist,
   - die Finger (8a) des ersten Fingersatzes (8) elektrisch mit den Fingern (12a) des vierten Fingersatzes (12) verbunden sind,
   - die Finger (9a) des zweiten Fingersatzes (9) elektrisch mit den Fingern 11a) des dritten Fingersatzes (11) verbunden sind.

6. Bauteil nach einem der vorstehenden Ansprüche, **dadurch gekennzeichnet, dass** die Finger (8a, 9a) des ersten Fingersatzes (8) und des zweiten Fingersatzes (9) zwischen der Anschlussfläche (7) und einer Ebene, die in Abstand zur Anschlussfläche (7) liegt und durch die erste, die zweite und die dritte elektrische Anschlussklemme (4, 5, 6) verläuft, ineinandergreifen.

7. Bauteil nach einem der vorstehenden Ansprüche, **dadurch gekennzeichnet, dass** die erste, die zweite und die dritte elektrische Anschlussklemme (4, 5, 6) am Umfang der Anschlussfläche (7) angeordnet sind, woraus sich das Vorhandensein eines der Anschlussfläche (7) gegenüberliegenden Volumens ergibt, in dem die Finger (8a, 9a) des ersten und des zweiten Fingersatzes (8, 9) angeordnet sind.

8. Bauteil nach einem der vorstehenden Ansprüche, **dadurch gekennzeichnet, dass** es sich bei dem Transistor (3) um einen ersten Transistor (3) handelt, bei dem die erste Elektrode (32) eine Source-Elektrode des ersten Transistors (3) ist, die zweite Elektrode (33) eine Drain-Elektrode des ersten Transistors (3) ist, und die Steuerelektrode (31) des ersten Transistors (3) eine Gate-Elektrode des ersten Transistors (3) ist, und dadurch, dass das elektronische Bauteil umfasst:

- einen zusätzlichen Transistor (15), der einen zweiten Transistor bildet, welcher mit einer Gate-Elektrode (151), einer Source-Elektrode (152) und einer Drain-Elektrode (153) ausgestattet ist,
- eine vierte elektrische Anschlussklemme (16), die sich auf der Anschlussfläche (7) erstreckt und elektrisch mit der Gate-Elektrode (151) des zweiten Transistors (15) verbunden ist,
- eine fünfte elektrische Anschlussklemme (17), die sich auf der Anschlussfläche (7) erstreckt und elektrisch mit der Drain-Elektrode (153) des zweiten Transistors (15) verbunden ist, wobei die Finger (9a) des zweiten Fingersatzes (9) elektrisch mit der fünften elektrischen Anschlussklemme (17) verbunden sind,

wobei die Source-Elektrode (152) des zweiten Transistors (15) elektrisch mit der zweiten elektrischen Anschlussklemme (5) verbunden ist, die erste elektrische Anschlussklemme (4) dazu bestimmt ist, mit einem negativen Gleichstrompotential einer elektrischen Versorgung verbunden zu werden, und die fünfte elektrische Anschlussklemme (17) dazu bestimmt ist, mit einem positiven Gleichstrompotential der elektrischen Versorgung verbunden zu werden, woraus sich ergibt, dass die zweite elektrische Anschlussklemme (5) einen Ausgang bildet, der in der Lage ist, einen Wechselstrom zu liefern.

9. Vorrichtung zur Umwandlung von elektrischer Energie, **dadurch gekennzeichnet, dass** sie ein erstes elektronisches Bauteil (1000) nach einem der Ansprüche 1 bis 7, und ein zweites elektronisches Bauteil (2000) nach einem der Ansprüche 1 bis 7 umfasst, und dadurch, dass:

- die erste Elektrode (1032) des Transistors (1003) des ersten elektronischen Bauteils (1000) eine Source-Elektrode ist und dazu bestimmt ist, elektrisch mit einem negativen Gleichstrompotential einer elektrischen Versorgung (200) der Vorrichtung verbunden zu werden,
- die zweite Elektrode (1033) des Transistors (1003) des ersten elektronischen Bauteils (1000) eine Drain-Elektrode ist und dazu bestimmt ist, elektrisch mit einem Wechselstromausgang der Vorrichtung verbunden zu werden,
- die Steuerelektrode (1031) des Transistors (1003) des ersten elektronischen Bauteils (1000) eine Gate-Elektrode ist,
- die erste Elektrode (2032) des Transistors (2003) des zweiten elektronischen Bauteils (2000) eine Drain-Elektrode ist und dazu bestimmt ist, elektrisch mit einem positiven Gleichstrompotential der elektrischen Versorgung (200) der Vorrichtung verbunden zu werden,
- die zweite Elektrode (2033) des Transistors (2003) des zweiten elektronischen Bauteils (2000) eine Source-Elektrode ist und dazu bestimmt ist, mit dem Wechselstromausgang verbunden zu werden,
- die Steuerelektrode (2031) des Transistors (2003) des zweiten elektronischen Bauteils (2000) eine Gate-Elektrode ist,
- die Finger (1008a) des ersten Fingersatzes (1008) des ersten elektronischen Bauteils (1000) elektrisch mit den Fingern (2009a) des zweiten Fingersatzes des zweiten elektronischen Bauteils (2000) verbunden sind,
- die Finger (1009a) des zweiten Fingersatzes des ersten elektronischen Bauteils (1000) elektrisch mit den Fingern (2008a) des ersten Fingersatzes des zweiten elektronischen Bauteils (2000) verbunden sind.

10. Verfahren zur Herstellung eines elektronischen Bauteils nach Anspruch 1, wobei das Verfahren umfasst:

- einen Schritt des Bereitstellens (E1) des Teils (2) des elektronischen Bauteils (1), der den Transistor (3) umfasst, welcher mit der Steuerelektrode (31) und einer ersten und einer zweiten Elektrode (32, 33) ausgestattet ist, wobei der Teil (2) des elektronischen Bauteils (1) die Anschlussfläche (7) umfasst, die dazu bestimmt ist, die Bildung von elektrischen Anschlussklemmen des elektronischen Bauteils zu ermöglichen,
- einen Schritt des Bildens (E2) der ersten, der zweiten und der dritten elektrischen Anschlussklemme (4, 5, 6) des elektronischen Bauteils (1) im Bereich der Anschlussfläche (7) derart, dass:

  ◦ die erste elektrische Anschlussklemme (4) elektrisch mit der ersten Elektrode (32) des Transistors (3) verbunden ist,
  ◦ die zweite elektrische Anschlussklemme (5) elektrisch mit der zweiten Elektrode (33) des Transistors (3) verbunden ist, und
  ◦ die dritte elektrische Anschlussklemme (6) elektrisch mit der Steuerelektrode (31) des Transistors (3) verbunden ist,

- einen Schritt des Bildens (E3) des ersten Satzes (8) elektrisch leitender Finger (8a) und des zweiten Satzes (9) elektrisch leitender Finger (9a) derart, dass:

  ◦ die Finger (8a, 9a) des ersten Fingersatzes (8) und des zweiten Fingersatzes (9) im Bereich der Anschlussfläche (7) ineinandergreifen, um den mindestens einen Teil eines kapazitiven Bauteils zu bilden, und
  ◦ die Finger (8a) des ersten Fingersatzes (8) elektrisch mit der ersten elektrischen Anschlussklemme (4) verbunden sind.

11. Verfahren nach dem vorstehenden Anspruch, **dadurch gekennzeichnet, dass** der Schritt des Bildens (E2) der ersten, der zweiten und der dritten elektrischen Anschlussklemme (4, 5, 6) und der Schritt des Bildens (E3) des ersten Satzes (8) elektrisch leitender Finger (8a) und des zweiten Satzes (9) elektrisch leitender Finger (9a) derart sind, dass mindestens ein Teil (4a) der ersten elektrischen Anschlussklemme (4), und mindestens ein Teil jedes der Finger (8a) des ersten Fingersatzes (8) gleichzeitig gebildet werden.

12. Verfahren nach dem vorstehenden Anspruch, **dadurch gekennzeichnet, dass** der mindestens eine Teil (4a) der ersten elektrischen Anschlussklemme (4), und der mindestens eine Teil jedes der Finger (8a) des ersten Fingersatzes (8) gleichzeitig gebildet werden durch:

  - einen Schritt des Bildens einer elektrisch leitenden Schicht (18) auf der Anschlussfläche (7), und anschließend
  - einen Schritt des Ätzens der elektrisch leitenden Schicht (18).

13. Verfahren nach dem vorstehenden Anspruch, **dadurch gekennzeichnet, dass** der Schritt des Ätzens der elektrisch leitenden Schicht (18) derart ist, dass:

  - für jede aus der ersten, der zweiten und der dritten Anschlussklemme (4, 5, 6) ein elektrisch leitendes Glied (4a, 5a, 6a) gebildet wird, und
  - die Finger des ersten Fingersatzes mit dem Glied der ersten elektrischen Anschlussklemme einen Stoffschluss bilden.

14. Verfahren nach einem der Ansprüche 10 bis 11, **dadurch gekennzeichnet, dass** der Schritt des Bildens der ersten, der zweiten und der dritten elektrischen Anschlussklemme (4, 5, 6) einen Schritt des Ausbildens, für jede aus der ersten, der zweiten und der dritten elektrischen Anschlussklemme, eines elektrisch leitenden Glieds umfasst, das von elektrisch leitenden Pfeilern überragt wird, und dadurch, dass mindestens ein Teil jedes der Finger (8a, 9a) des ersten und des zweiten Fingersatzes (8,9) und die Pfeiler gleichzeitig durch Züchtung gemäß einer Züchtmaske (21) gebildet werden.

**Claims**

1. An electronic component (1) including a part (2) incorporating a transistor (3) provided with a control electrode (31) and with first and second electrodes (32, 33), the electronic component (1) comprising first, second and third electrical connection terminals (4, 5, 6) extending on a connection face (7) of said part (2) incorporating the transistor (3), the first electrical connection terminal (4) being electrically linked with the first electrode (32), the second electrical connection terminal (5) being electrically linked with the second electrode (33) and the third electrical connection terminal (6) being electrically linked with the control electrode (31), the electronic component (1) comprising a first set (8) of electrically conductive fingers and a second set (9) of electrically conductive fingers, the fingers (8a, 9a) of the first and second sets (8, 9) of fingers being interdigitated, at the connection face (7), to form at least a part of a capacitive component, and the fingers (8a) of the first set (8) of fingers being electrically linked to the first electrical connection terminal (4), the first electrical connection terminal (4) comprising an electrically conductive member (4a) extending on the connection face (7), **characterized in that** the first electrical connection terminal (4) comprises a plurality of pillars (4b) linked electrically to the member (4a) arranged between the pillars (4b) and the connection face (7).

2. The component according to the preceding claim, **characterized in that** the fingers (8a, 9a) of the first set (8) of fingers and of the second set (9) of fingers extend along their length parallel to the connection face (7).

3. The component according to any one of the preceding claims, **characterized in that** at least a part of each finger (8a) of the first set of fingers (8) forms a continuity of material with at least a part of the first electrical connection terminal (4).

4. The component according to any one of the preceding claims, **characterized in that**:

   - the fingers (8a) of the first set of fingers (8) form a continuity of material with the electrically conductive member (4a) of the first electrical connection terminal (4), or
   - each finger (8a) of the first set of fingers (8) comprises a first longitudinal part (81) and a second longitudinal part (82), the first part (81) being arranged between the second part (82) and the connection face (7), said first parts forming, with the member (4a), a first continuity of material, and said second parts (82) each forming, with a corresponding pillar (4b) of the first electrical connection terminal (4), a second continuity of material, or
   - each finger (8a) of the first set of fingers forms a continuity of material with at least one pillar (4b) of the first connection terminal (4).

5. The component according to any one of claims 1 to 3, **characterized in that** the fingers (8a) of the first set (8) of fingers form a continuity of material with the electrically conductive member (4a) of the first electrical connection terminal (4), and **in that** the electronic component comprises a third set (11) of electrically conductive fingers (11a) and a fourth set (12) of electrically conductive fingers (12a), the fingers (11a, 12a) of the third set (11) of fingers and of the fourth set (12) of fingers being interdigitated, each finger (12a) of the fourth set (12) of fingers forming, with at least one pillar (4b) of the first electrical connection terminal (4), a continuity of material, and **in that**:

   - each finger (8a) of the first set (8) of fingers comprises a longitudinal part arranged between a longitudinal part of a finger (11a) of the third set (11) of fingers and the connection face (7),
   - each finger (9a) of the second set (9) of fingers comprises a longitudinal part arranged between a longitudinal part of a finger (12a) of the fourth set (12) of fingers and the connection face (7),
   - the fingers (8a) of the first set (8) of fingers are electrically linked to the fingers (12a) of the fourth set (12) of fingers,
   - the fingers (9a) of the second set (9) of fingers are electrically linked to the fingers 11a) of the third set (11) of fingers.

6. The component according to any one of the preceding claims, **characterized in that** the fingers (8a, 9a) of the first set (8) of fingers and of the second set (9) of fingers are interdigitated between the connection face (7) and a plane situated at a distance from the connection face (7) and passing through the first, second and third electrical connection terminals (4, 5, 6).

7. The component according to any one of the preceding claims, **characterized in that** the first, second and third electrical connection terminals (4, 5, 6) are arranged at the periphery of the connection face (7) resulting in the presence of a volume facing the connection face (7) within which the fingers (8a, 9a) of the first and second set (8, 9) of fingers are arranged.

8. The component according to any one of the preceding claims, **characterized in that** said transistor (3) is a first transistor (3) of which the first electrode (32) is a source electrode of the first transistor (3), the second electrode (33) is a drain electrode of the first transistor (3), and the control electrode (31) of the first transistor (3) is a gate electrode of the first transistor (3), and **in that** the electronic component comprises:

   - an additional transistor (15) forming a second transistor provided with a gate electrode (151), a source electrode (152) and a drain electrode (153),
   - a fourth electrical connection terminal (16) extending on the connection face (7) and electrically linked to the gate electrode (151) of the second transistor (15),
   - a fifth electrical connection terminal (17) extending on the connection face (7) and being electrically linked to the drain electrode (153) of the second transistor (15), the fingers (9a) of the second set (9) of fingers being electrically linked to the fifth electrical connection terminal (17),

   the source electrode (152) of the second transistor (15) being electrically linked to the second electrical connection terminal (5), the first electrical connection terminal (4) being intended to be linked to a direct current negative potential of an electrical power supply, and the fifth electrical connection terminal (17) being intended to be linked to a direct current positive potential of the electrical power supply with the result that the second electrical connection terminal (5) forms an output capable of supplying an alternating current.

9.  A device for converting electrical energy, **characterized in that** it includes a first electronic component (1000) according to any one of claims 1 to 7 and a second electronic component (2000) according to any one of claims 1 to 7, and **in that**:

    - the first electrode (1032) of the transistor (1003) of the first electronic component (1000) is a source electrode, and is intended to be electrically linked to a direct current negative potential of an electrical power supply (200) of the device,
    - the second electrode (1033) of the transistor (1003) of the first electronic component (1000) is a drain electrode, and is intended to be electrically linked to an alternating current output of the device,
    - the control electrode (1031) of the transistor (1003) of the first electronic component (1000) is a gate electrode,
    - the first electrode (2032) of the transistor (2003) of the second electronic component (2000) is a drain electrode, and is intended to be electrically linked to a direct current positive potential of the electrical power supply (200) of the device,
    - the second electrode (2033) of the transistor (2003) of the second electronic component (2000) is a source electrode, and is intended to be linked to the alternating current output,
    - the control electrode (2031) of the transistor (2003) of the second electronic component (2000) is a gate electrode,
    - the fingers (1008a) of the first set (1008) of fingers of the first electronic component (1000) are electrically linked to the fingers (2009a) of the second set of fingers of the second electronic component (2000),
    - the fingers (1009a) of the second set of fingers of the first electronic component (1000) are electrically linked to the fingers (2008a) of the first set of fingers of the second electronic component (2000).

10. A method for fabricating an electronic component according to claim 1, said method comprising:

    - a step of supply (E1) of the part (2) of the electronic component (1) comprising the transistor (3) provided with the control electrode (31) and first and second electrodes (32, 33), said part (2) of the electronic component (1) comprising the connection face (7) intended to allow the formation of electrical connection terminals of the electronic component,
    - a step of formation (E2) of the first, second and third electrical connection terminals (4, 5, 6) of said electronic component (1) at the connection face (7) such that:

        ◦ the first electrical connection terminal (4) is electrically linked to the first electrode (32) of the transistor (3),
        ◦ the second electrical connection terminal (5) is electrically linked to the second electrode (33) of the transistor (3) and,
        ◦ the third electrical connection terminal (6) is electrically linked to the control electrode (31) of the transistor (3),

    - a step of formation (E3) of the first set (8) of electrically conductive fingers (8a) and of the second set (9) of electrically conductive fingers (9a) such that:

        ◦ the fingers (8a, 9a) of the first set (8) of fingers and of the second set (9) of fingers are interdigitated, at the connection face (7), to form said at least a part of a capacitive component, and
        ◦ the fingers (8a) of the first set (8) of fingers are electrically linked to the first electrical connection terminal (4).

11. The method according to the preceding claim, **characterized in that** the step of formation (E2) of the first, second and third electrical connection terminals (4, 5, 6) and the step of formation (E3) of the first set (8) of electrically conductive fingers (8a) and of the second set (9) of electrically conductive fingers (9a) are such that at least a part (4a) of the first electrical connection terminal (4), and at least a part of each of the fingers (8a) of the first set (8) of fingers are formed simultaneously.

12. The method according to the preceding claim, **characterized in that** said at least a part (4a) of the first electrical connection terminal (4) and said at least a part of each of the fingers (8a) of the first set (8) of fingers are formed simultaneously by:

    - a step of formation of an electrically conductive layer (18) on the connection face (7), then
    - a step of etching of said electrically conductive layer (18).

13. The method according to the preceding claim, **characterized in that** the step of etching of the electrically conductive layer (18) is such that:

  - an electrically conductive member (4a, 5a, 6a) is formed for each of the first, second and third connection terminals (4, 5, 6), and
  - the fingers of the first set of fingers form, with the member of the first electrical connection terminal, a continuity of material.

14. The method according to any one of claims 10 to 11, **characterized in that** the step of formation of the first, second and third electrical connection terminals (4, 5, 6) comprises a step of production, for each of the first, second and third electrical connection terminals, of an electrically conductive member topped by electrically conductive pillars, and **in that** at least a part of each of the fingers (8a, 9a) of the first and second sets (8,9) of fingers and the pillars are formed simultaneously by growth according to a growth mask (21).

100

+DC

403

200

402

400

401

500

303

302

300

-DC

301

Figure 1 (art antérieur)

9

A1

6

6c

6a

6b

1

7

7a

A2

3

4

2

4c

5c

4b

5b

4a

5

8

8a

9a

9b

40

5a

Figure 2

Figure 3

Figure 4 (art antérieur)

Figure 5

Figure 6

Figure 7

Figure 8

Figure 9

Figure 10

Figure 11

Figure 12

Figure 13

E1

E3

E2

Figure 14

18

2

7

Figure 15

19

7

Figure 16

13

4a

6a

7

Figure 17

Figure 18

Figure 19

## RÉFÉRENCES CITÉES DANS LA DESCRIPTION

**Documents brevets cités dans la description**

- US 20150155377 A
- US 20080291603 A
- US 20030183864 A
- US 20060006496 A

**Littérature non-brevet citée dans la description**

- **AKINOBU SHIBUYA et al.** A Silicon Interposer With an Integrated SrTiO3 Thin Film Decoupling Capacitor and Through-Silicon Vias. *IEEE Transactions on components and packaging technologies,* Septembre 2010, vol. 33 (3), 582-587
- **KAZUKIYO JOSHIN et al.** Outlook for GaN HEMT Technology. *Fujitsu Sci. Tech. J.,* Janvier 2014, vol. 50 (1), 138-143